# EUROPEAN PATENT APPLICATION

(11) **EP 4 734 721 A1**
(43) Date of publication of application: **29.04.2026**
(21) Application number: 24826052.3
(22) Date of filing: 15.01.2024
(51) Int. Cl.: H10K 59/121, H10K 59/131, H10K 59/124, H10K 59/123, H10K 59/80

(54) **DISPLAY DEVICE**

(30) Priority: 20.06.2023 KR 20230079224
(71) Applicant: Samsung Display Co., Ltd., Yongin-si, Gyeonggi-do 17113 (KR)
(72) Inventor: KIM, Jong In, Yongin-si Gyeonggi-do 17113 (KR); KANG, Hyun Seong, Yongin-si Gyeonggi-do 17113 (KR); RA, Yoo Mi, Yongin-Si Gyeonggi-do 17113 (KR); SON, Seung Sok, Yongin-Si Gyeonggi-do 17113 (KR); YOON, Kap Soo, Yongin-si Gyeonggi-do 17113 (KR); LEE, Keum Hee, Yongin-si Gyeonggi-do 17113 (KR); LEE, Doo Young, Yongin-si Gyeonggi-do 17113 (KR); LEE, Seong Young, Yongin-si Gyeonggi-do 17113 (KR); LEE, Woo Geun, Yongin-Si Gyeonggi-do 17113 (KR); HONG, Ji Yun, Yongin-si Gyeonggi-do 17113 (KR)
(74) Representative: Marks & Clerk LLP
(86) International application number: PCT/KR2024/000670
(87) International publication number: WO 2024/262727

(57) **Abstract**

This display device comprises: a first voltage line; a data line spaced apart from the first voltage line; a first capacitor electrode arranged between the first voltage line and the data line; a buffer layer arranged on the first voltage line, the data line, and the first capacitor electrode; a second capacitor electrode arranged on the buffer layer and arranged on the first capacitor electrode; a first transistor arranged on the buffer layer and connected to the data line; an interlayer insulating layer arranged on the second capacitor electrode and the first transistor; and a first connection pattern arranged on the interlayer insulating layer and connected to the second capacitor electrode and the first transistor, wherein the first connection pattern is connected to the second capacitor electrode through a first contact hole and connected to the first transistor through a second contact hole, and the first capacitor electrode overlaps the first connection pattern.

## Description

### [TECHNICAL FIELD]

The present disclosure relates to a display device.

### [BACKGROUND ART]

As the information society develops, demands for display devices for displaying images are increasing in various forms. For example, display devices are applied to various electronic devices such as smartphones, digital cameras, notebook computers, navigation devices, and smart televisions.

The display devices may be flat panel display devices such as liquid crystal display devices, field emission display devices, and light emitting display devices. The light emitting display devices may include an organic light emitting display device including an organic light emitting element, an inorganic light emitting display device including an inorganic light emitting element such as an inorganic semiconductor, and a micro- or nano-light emitting display device including a micro- or nano-light emitting element.

### [DISCLOSURE]

### [TECHNICAL PROBLEM]

Aspects of the present disclosure provide a display device capable of securing capacitance at a high resolution.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

### [TECHNICAL SOLUTION]

According to an aspect of the present disclosure, a display device comprises a first voltage line disposed on a substrate and supplying a high potential voltage, a data line spaced apart from the first voltage line and supplying a data voltage, a first capacitor electrode disposed between the first voltage line and the data line, a buffer layer disposed on the first voltage line, the data line, and the first capacitor electrode, a second capacitor electrode disposed on the buffer layer and disposed on the first capacitor electrode, a first transistor disposed on the buffer layer and connected to the data line, an interlayer insulating layer disposed on the second capacitor electrode and the first transistor, and a first connection pattern disposed on the interlayer insulating layer and connected to the second capacitor electrode and the first transistor, wherein the first connection pattern is connected to the second capacitor electrode through a first contact hole penetrating the interlayer insulating layer and connected to the first transistor through a second contact hole penetrating the interlayer insulating layer, and the first capacitor electrode overlaps the first connection pattern.

The first capacitor electrode may overlap the first contact hole and may not overlap the second contact hole.

The first capacitor electrode may not overlap the first contact hole and may overlap the second contact hole.

A capacitor may be formed between the first capacitor electrode and a source electrode of the first transistor.

The first capacitor electrode may overlap the first contact hole and the second contact hole.

The display device may further comprise a second transistor disposed on the buffer layer, and a second connection pattern overlapping the second transistor and disposed on the interlayer insulating layer, wherein the second transistor may be electrically connected to the first voltage line.

The display device may further comprise a first via layer disposed on the interlayer insulating layer, the first connection pattern, and the second connection pattern, and a first connection electrode disposed on the first via layer and connected to the second connection pattern through a third contact hole penetrating the first via layer.

The first connection pattern, the first connection electrode and the first capacitor electrode may overlap each other, and a capacitor may be formed between the first connection pattern and the first connection electrode.

The second connection pattern may be connected to the second transistor through a fourth contact hole penetrating the interlayer insulating layer and may be connected to the first capacitor electrode through a fifth contact hole penetrating the interlayer insulating layer and the buffer layer.

A capacitor may be formed between the first capacitor electrode and the second capacitor electrode and between the second capacitor electrode and the second connection pattern.

According to an aspect of the present disclosure, a display device comprises a first voltage line disposed on a substrate and supplying a high potential voltage, a data line spaced apart from the first voltage line and supplying a data voltage, a first capacitor electrode disposed between the first voltage line and the data line, a buffer layer disposed on the first voltage line, the data line, and the first capacitor electrode, a second capacitor electrode disposed on the buffer layer and disposed on the first capacitor electrode, a first transistor disposed on the buffer layer and connected to the data line and a second transistor connected to the first voltage line, an interlayer insulating layer disposed on the second capacitor electrode, the first transistor, and the second transistor, a first connection pattern disposed on the interlayer insulating layer and connected to the second capacitor electrode and the first transistor and a second connection pattern connected to the first capacitor electrode and the second transistor, a passivation layer disposed on the interlayer insulating layer, the first connection pattern, and the second connection pattern, a first via layer disposed on the passivation layer, and a first connection electrode disposed on the first via layer and connected to the second connection pattern through a third contact hole penetrating the passivation layer and the first via layer, wherein the first connection pattern is connected to the second capacitor electrode through a first contact hole penetrating the interlayer insulating layer and connected to the first transistor through a second contact hole penetrating the interlayer insulating layer, the first via layer comprises an opening overlapping at least one of the first contact hole and the second contact hole, and the first connection electrode is disposed on the first via layer and the opening.

The opening of the first via layer may penetrate the first via layer to expose an upper surface of the passivation layer, and the first connection electrode may extend from an upper surface of the first via layer to the upper surface of the passivation layer.

The first connection electrode and the first connection pattern may overlap each other, and a capacitor may be formed between the first connection electrode and the first connection pattern.

The opening of the first via layer may not overlap the first capacitor electrode.

The first capacitor electrode may overlap the first contact hole, and the opening of the first via layer may overlap the first contact hole and the first capacitor electrode.

The first capacitor electrode may overlap the first contact hole and the second contact hole, and the opening of the first via layer may overlap the first contact hole, the second contact hole and the first capacitor electrode.

The first capacitor electrode may overlap the second contact hole, and the opening of the first via layer may overlap the second contact hole and the first capacitor electrode.

According to an aspect of the present disclosure, a display device comprises a first voltage line supplying a high potential voltage and extending in a first direction, a data line supplying a data voltage and extending in the first direction, a first transistor electrically connected to the first voltage line, a first connection pattern connected to the first transistor, a first capacitor electrode electrically connected to the first connection pattern to receive a high potential voltage, a second transistor electrically connected to the data line, a second connection pattern connected to the second transistor, a second capacitor electrode connected to the second connection pattern to receive a data voltage, an interlayer insulating layer disposed between the first transistor and the first connection pattern and between the second transistor and the second connection pattern, and a buffer layer disposed between the first voltage line, the first capacitor electrode and the data line and the first transistor and the second transistor, wherein the second connection pattern is connected to the second capacitor electrode and the second transistor through contact holes formed in the interlayer insulating layer, and the first capacitor electrode overlaps the first transistor and the second capacitor electrode and overlaps at least one of the contact holes.

The first capacitor electrode may overlap the whole of the second capacitor electrode.

The first capacitor electrode may overlap at least a portion of the second connection pattern.

The display device may further comprise a passivation layer disposed on the first connection pattern, the second connection pattern, and the interlayer insulating layer, a first via layer disposed on the passivation layer, and a first connection electrode disposed on the first via layer and electrically connected to the first connection pattern through a contact hole formed in the passivation layer and the first via layer, wherein the first connection electrode overlaps the second connection pattern.

The display device may further comprise a second via layer disposed on the first connection electrode and the first via layer, a pixel electrode disposed on the second via layer and electrically connected to the first connection electrode, an organic layer disposed on the pixel electrode, and a common electrode disposed on the organic layer.

Other features and embodiments may be apparent from the following detailed description and the drawings.

### [ADVANTAGEOUS EFFECTS]

A display device according to an embodiment may increase capacitance by increasing an overlap area between a first capacitor electrode and a second capacitor electrode. In addition, a first connection electrode may be further formed to form a capacitor between the first connection electrode and a third connection pattern, thereby increasing capacitance.

The effects according to the embodiments are not limited by the contents exemplified above, and more various effects are included in this disclosure.

### [DESCRIPTION OF DRAWINGS]

FIG. 1 is a plan view of a display device according to an embodiment;
FIG. 2 illustrates pixels and lines of the display device according to the embodiment;
FIG. 3 is a circuit diagram of a pixel of the display device according to the embodiment;
FIG. 4 is a plan view of a thin-film transistor layer of the display device according to the embodiment;
FIG. 5 is a plan view of a first metal layer of the thin-film transistor layer of FIG. 4;
FIG. 6 is a plan view of the first metal layer, an active layer and a second metal layer of the thin-film transistor layer of FIG. 4;
FIG. 7 is a plan view of the first metal layer, the active layer, the second metal layer and a third metal layer of the thin-film transistor layer of FIG. 4;
FIG. 8 is a cross-sectional view taken along line Q1-Q1' of FIG. 4;
FIG. 9 is a diagram of a first capacitor of the thin-film transistor layer;
FIG. 10 is a plan view of a thin-film transistor layer of a display device according to an embodiment;
FIG. 11 is a plan view of a first metal layer of the thin-film transistor layer of FIG. 10;
FIG. 12 is a cross-sectional view taken along line Q2-Q2' of FIG. 10;
FIG. 13 is a diagram of a first capacitor of the thin-film transistor layer;
FIG. 14 is a plan view of a thin-film transistor layer of a display device according to an embodiment;
FIG. 15 is a plan view of a first metal layer of the thin-film transistor layer of FIG. 14;
FIG. 16 is a cross-sectional view taken along line Q3-Q3' of FIG. 14;
FIG. 17 is a plan view of a thin-film transistor layer of a display device according to an embodiment;
FIG. 18 is a plan view of a fourth metal layer of the thin-film transistor layer of FIG. 17;
FIG. 19 is a cross-sectional view taken along line Q4-Q4' of FIG. 14;
FIG. 20 is a diagram of a first capacitor of the thin-film transistor layer;
FIG. 21 is a cross-sectional view of a thin-film transistor layer of a display device according to an embodiment;
FIG. 22 is a diagram of a first capacitor of the thin-film transistor layer;
FIG. 23 is a cross-sectional view of a thin-film transistor layer of a display device according to an embodiment;
FIG. 24 is a cross-sectional view of a thin-film transistor layer of a display device according to an embodiment;
FIG. 25 is a diagram of a capacitor in an area where a third contact hole is disposed;
FIG. 26 is a cross-sectional view of a thin-film transistor layer of a display device according to an embodiment;
FIG. 27 is a cross-sectional view of a thin-film transistor layer of a display device according to an embodiment;
FIG. 28 is a plan view of a display device according to an embodiment; and
FIG. 29 is a cross-sectional view taken along line Q5-Q5' of FIG. 28.

### [MODES OF THE INVENTION]

The advantages and features of the present invention, and the methods for achieving them, will become apparent with reference to the embodiments described in detail below together with the accompanying drawings. However, the present invention is not limited to the embodiments disclosed hereinafter but will be embodied in various different forms, and these embodiments are merely provided so that the disclosure of the present invention is complete and to fully inform those skilled in the art to which the present invention pertains of the scope of the invention, and the present invention is defined by the scope of the claims.

When an element or a layer is referred to as being "on" another element or layer, this includes both a case where it is directly on the other element, and a case where another layer or element is interposed therebetween. Likewise, references to "below," "left," and "right" of another element also include both cases where they are directly adjacent and cases where another layer or material is interposed therebetween. Throughout the specification, the same reference numerals refer to the same components.

Although terms such as first, second, etc. are used to describe various components, these components are not limited by these terms. These terms are merely used to distinguish one component from another. Thus, a first component mentioned below may also be a second component within the technical spirit of the present invention.

Hereinafter, embodiments of the present disclosure will be described with reference to the drawings.

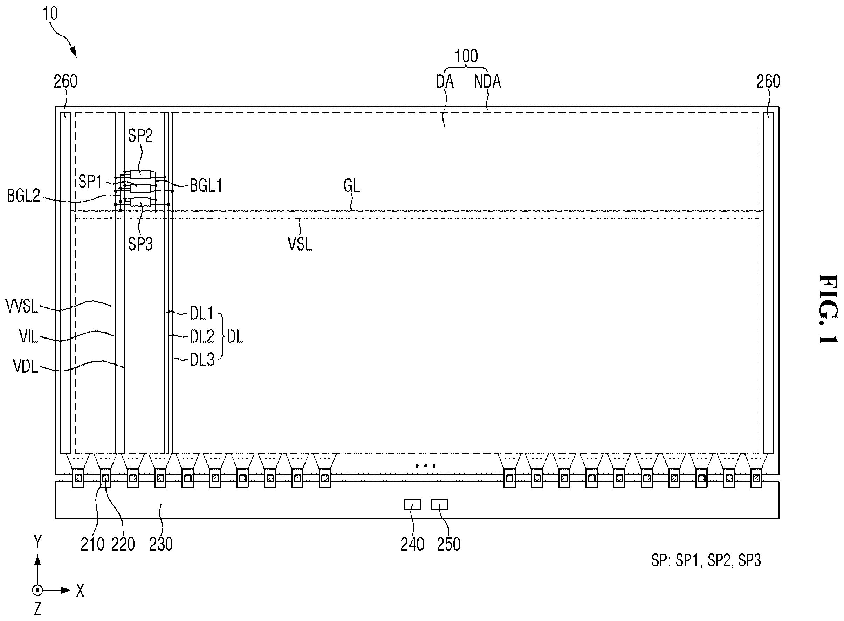

FIG. 1 is a plan view of a display device according to an embodiment.

In the present specification, "above," "top" and "upper surface" refer to an upward direction from a display device, that is, a Z-axis direction, and "below," "bottom" and "lower surface" refer to a downward direction from the display device, that is, a direction opposite to the Z-axis direction. In addition, "left," "right," "upper," and "lower" refer to directions when the display device is seen in plan view. For example, "left" refers to a direction opposite to an X-axis direction, "right" refers to the X-axis direction, "upper" refers to a Y-axis direction, and "lower" refers to a direction opposite to the Y-axis direction.

Referring to FIG. 1, the display device 10 is a device for displaying moving images or still images. The display device 10 may be used as a display screen in portable electronic devices such as mobile phones, smartphones, tablet personal computers (PCs), smart watches, watch phones, mobile communication terminals, electronic notebooks, electronic books, portable multimedia players (PMPs), navigation devices and ultra-mobile PCs (UMPCs), as well as in various products such as televisions, notebook computers, monitors, billboards and Internet of things (loT) devices.

The display device 10 may include a display panel 100, flexible films 210, display drivers 220, a circuit board 230, a timing controller 240, a power supply 250, and gate drivers 260.

The display panel 100 may be rectangular in plan view. For example, the display panel 100 may be shaped like a rectangular plane having long sides in a first direction (X-axis direction) and short sides in a second direction (Y-axis direction). Each corner where a long side extending in the first direction (X-axis direction) meets a short side extending in the second direction (Y-axis direction) may be right-angled or may be rounded with a predetermined curvature. The planar shape of the display panel 100 is not limited to a rectangular shape and may also be another polygonal shape, a circular shape, or an oval shape. For example, the display panel 100 may be formed flat, but the present disclosure is not limited thereto. For another example, the display panel 100 may be formed to be bent with a predetermined curvature.

The display panel 100 may include a display area DA and a non-display area NDA.

The display area DA may be an area for displaying an image and may be defined as a central area of the display panel 100. The display area DA may include pixels SP, gate lines GL, data lines DL, initialization voltage lines VIL, first voltage lines VDL, vertical voltage lines VVSL, and second voltage lines VSL. The pixels SP may be respectively formed in pixel areas intersected by the data lines DL and the gate lines GL. The pixels SP may include first through third pixels SP1 through SP3. Each of the first through third pixels SP1 through SP3 may be connected to a gate line GL and a data line DL. Each of the first through third pixels SP1 through SP3 may be defined as a minimum unit area that outputs light.

Each of the first through third pixels SP1 through SP3 may include an organic light emitting diode including an organic light emitting layer, a quantum dot light emitting diode including a quantum dot light emitting layer, a micro-light emitting diode, or an inorganic light emitting diode including an inorganic semiconductor.

The first pixels SP1 may emit light of a first color or red light, the second pixels SP2 may emit light of a second color or green light, and the third pixels SP3 may emit light of a third color or blue light. Pixel circuits of the second pixels SP2, pixel circuits of the first pixels SP1, and pixel circuits of the third pixels SP3 may be arranged in the direction opposite to the second direction (Y-axis direction), but the order of the pixel circuits is not limited thereto.

The gate lines GL may extend in the first direction (X-axis direction) and may be spaced apart from each other in the second direction (Y-axis direction). The gate lines GL may receive gate signals from the gate drivers 260 and supply the gate signals to first auxiliary gate lines BGL1 and second auxiliary gate lines BGL2. The first auxiliary gate lines BGL1 and the second auxiliary gate lines BGL2 may extend from the gate lines GL to supply the gate signals to the first through third pixels SP1 through SP3.

The data lines DL may extend in the second direction (Y-axis direction) and may be spaced apart from each other in the first direction (X-axis direction). The data lines DL may include first through third data lines DL1 through DL3. The first through third data lines DL1 through DL3 may supply data voltages to the first through third pixels SP1 through SP3, respectively.

The initialization voltage lines VIL may extend in the second direction (Y-axis direction) and may be spaced apart from each other in the first direction (X-axis direction). The initialization voltage lines VIL may supply initialization voltages received from the display drivers 220 to the pixel circuits of the first through third pixels SP1 through SP3. The initialization voltage lines VIL may receive sensing signals from the pixel circuits of the first through third pixels SP1 through SP3 and supply the sensing signals to the display drivers 220.

The first voltage lines VDL may extend in the second direction (Y-axis direction) and may be spaced apart from each other in the first direction (X-axis direction). The first voltage lines VDL may supply a driving voltage or a high potential voltage received from the power supply 250 to the first through third pixels SP1 through SP3.

The vertical voltage lines VVSL may extend in the second direction (Y-axis direction) and may be spaced apart from each other in the first direction (X-axis direction). The vertical voltage lines VVSL may be connected to the second voltage lines VSL. The vertical voltage lines VVSL may supply a low potential voltage received from the power supply 250 to the second voltage lines VSL.

The second voltage lines VSL may extend in the first direction (X-axis direction) and may be spaced apart from each other in the second direction (Y-axis direction). The second voltage lines VSL may supply a low potential voltage to the first through third pixels SP1 through SP3.

The connection relationship between the pixels SP, the gate lines GL, the data lines DL, the initialization voltage lines VIL, the first voltage lines VDL, and the second voltage lines VSL may be designed and changed according to the number and arrangement of the pixels SP.

The non-display area NDA may be defined as an area other than the display area DA in the display panel 100. For example, the non-display area NDA may include fan-out lines connecting the data lines DL, the initialization voltage lines VIL, the first voltage lines VDL and the vertical voltage lines VVSL to the display drivers 220 and may include the gate drivers 260 and pad units (not illustrated) connected to the flexible films 210.

The flexible films 210 may be connected to the pad units disposed on a lower side of the non-display area NDA. Input terminals disposed on one side of the flexible films 210 may be attached to the circuit board 230 by a film attaching process, and output terminals disposed on the other side of the flexible films 210 may be attached to the pad units by a film attaching process. For example, each of the flexible films 210 may be bent like a tape carrier package or a chip on film. The flexible films 210 may be bent toward the bottom of the display panel 100 to reduce a bezel area of the display device 10.

The display drivers 220 may be mounted on the flexible films 210. For example, the display drivers 220 may be implemented as integrated circuits (ICs). The display drivers 220 may receive digital video data and a data control signal from the timing controller 240, convert the digital video data into analog data voltages according to the data control signal, and supply the analog data voltages to the data lines DL through the fan out lines.

The circuit board 230 may support the timing controller 240 and the power supply 250 and supply signals and power to the display drivers 220. For example, the circuit board 230 may supply a signal supplied from the timing controller 240 and a power supply voltage supplied from the power supply 250 to the flexible films 210 and the display drivers 220 to display an image on each pixel. To this end, signal lines and power lines may be provided on the circuit board 230.

The timing controller 240 may be mounted on the circuit board 230 and may receive image data and a timing synchronization signal from a display driving system or a graphics device through a user connector provided on the circuit board 230. The timing controller 240 may generate digital video data by arranging the image data according to the pixel arrangement structure based on the timing synchronization signal and supply the generated digital video data to the display drivers 220. The timing controller 240 may generate a data control signal and a gate control signal based on the timing synchronization signal. The timing controller 240 may control the supply timing of data voltages of the display drivers 220 based on the data control signal and may control the supply timing of gate signals of the gate drivers 260 based on the gate control signal.

The power supply 250 may be disposed on the circuit board 230 to supply a power supply voltage to the flexible films 210 and the display drivers 220. For example, the power supply 250 may generate a driving voltage or a high potential voltage and supply the driving voltage or the high potential voltage to the first voltage lines VDL, may generate a low potential voltage and supply the low potential voltage to the vertical voltage lines VVSL, and may generate an initialization voltage and supply the initialization voltage to the initialization voltage lines VIL.

The gate drivers 260 may be disposed on left and right sides of the non-display area NDA. The gate drivers 260 may generate gate signals based on a gate control signal supplied from the timing controller 240. The gate control signal may include, but is not limited to, a start signal, a clock signal, and a power supply voltage. The gate drivers 260 may supply the gate signals to the gate lines GL according to a set order.

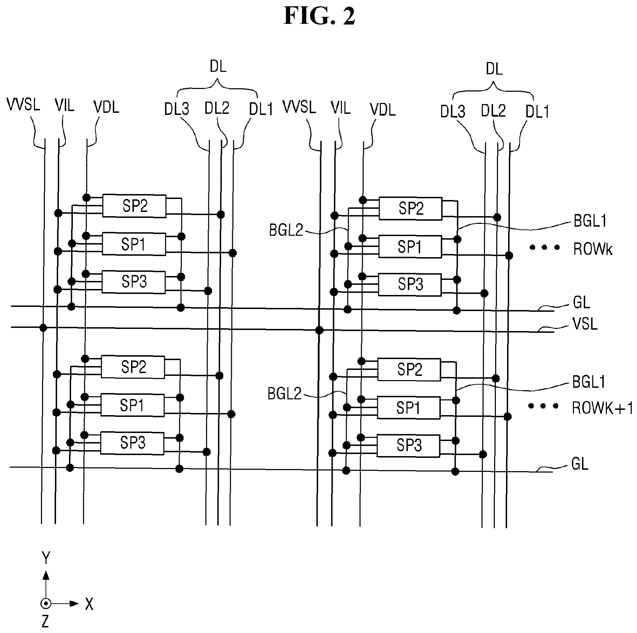

FIG. 2 illustrates pixels and lines of the display device according to the embodiment.

Referring to FIG. 2, the pixels SP may include the first through third pixels SP1 through SP3. The pixel circuits of the second pixels SP2, the pixel circuits of the first pixels SP1, and the pixel circuits of the third pixels SP3 may be arranged in the direction opposite to the second direction (Y-axis direction), but the order of the pixel circuits is not limited thereto.

Each of the first through third pixels SP1 through SP3 may be connected to a first voltage line VDL, an initialization voltage line VIL, a gate line GL, and a data line DL.

The first voltage lines VDL may extend in the second direction (Y-axis direction). The first voltage lines VDL may be disposed on left sides of the pixel circuits of the first through third pixels SP1 through SP3. The first voltage lines VDL may supply a driving voltage or a high potential voltage to transistors of the first through third pixels SP1 through SP3.

The initialization voltage lines VIL may extend in the second direction (Y-axis direction). The initialization voltage lines VIL may be disposed on left sides of the second auxiliary gate lines BGL2. The initialization voltage lines VIL may be disposed between the vertical voltage lines VVSL and the second auxiliary gate lines BGL2. The initialization voltage lines VIL may supply an initialization voltage to the pixel circuits of the first through third pixels SP1 through SP3. The initialization voltage lines VIL may receive sensing signals from the pixel circuits of the first through third pixels SP1 through SP3 and supply the sensing signals to the display drivers 220.

The vertical voltage lines VVSL may extend in the second direction (Y-axis direction). The vertical voltage lines VVSL may be disposed on left sides of the initialization voltage lines VIL. The vertical voltage lines VVSL may be connected between the power supply 250 and a second voltage line VSL. The vertical voltage lines VVSL may supply a low potential voltage supplied from the power supply 250 to the second voltage line VSL.

The second voltage line VSL may extend in the first direction (X-axis direction). The second voltage line VSL may be disposed below a gate line GL disposed in a k^{th}+1 row ROWk+1. The second voltage line VSL may supply low potential voltages received from the vertical voltage lines VVSL to light emitting element layers of the first through third pixels SP1 through SP3.

The gate lines GL may extend in the first direction (X-axis direction). The gate lines GL may be disposed below the pixel circuits of the third pixels SP3. Each of the gate lines GL may supply a gate signal received from the gate drivers 260 to the first auxiliary gate lines BGL1 and the second auxiliary gate lines BGL2. The first auxiliary gate lines BGL1 and the second auxiliary gate lines BGL2 may extend from each of the gate lines GL in the second direction (Y-axis direction). Each of the first auxiliary gate lines BGL1 may be disposed on right sides of the pixel circuits of the first through third pixels SP1 through SP3, and each of the second auxiliary gate lines BGL2 may be disposed on the left sides of the pixel circuits of the first through third pixels SP1 through SP3. Each of the first auxiliary gate lines BGL1 and the second auxiliary gate lines BGL2 may supply a gate signal received from a gate line GL to the pixel circuits of the first through third pixels SP1 through SP3.

The data lines DL may extend in the second direction (Y-axis direction). The data lines DL may supply data voltages to the pixels SP. The data lines DL may include the first through third data lines DL1 through DL3.

The first data lines DL1 may extend in the second direction (Y-axis direction). The first data lines DL1 may be disposed on right sides of the second data lines DL2. The first data lines DL1 may supply data voltages received from the display drivers 220 to the pixel circuits of the first pixels SP1.

The second data lines DL2 may extend in the second direction (Y-axis direction). The second data lines DL2 may be disposed on left sides of the first data lines DL1. The second data lines DL2 may supply data voltages received from the display drivers 220 to the pixel circuits of the second pixels SP2.

The third data lines DL3 may extend in the second direction (Y-axis direction). The third data lines DL3 may be disposed on left sides of the second data lines DL2. The third data lines DL3 may supply data voltages received from the display drivers 220 to the pixel circuits of the third pixels SP3.

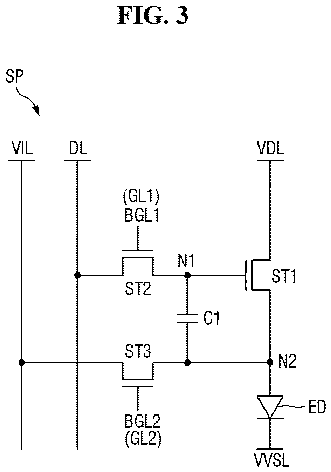

FIG. 3 is a circuit diagram of a pixel of the display device according to the embodiment.

Referring to FIG. 3, each of the pixels SP may be connected to a first voltage line VDL, a data line DL, an initialization voltage line VIL, a gate line GL, and a vertical voltage line VVSL.

Each of the first through third pixels SP1 through SP3 may include a pixel circuit and a light emitting element ED. The pixel circuit of each of the first through third pixels SP1 through SP3 may include first through third transistors ST1 through ST3 and a first capacitor C1.

The first transistor ST1 may include a gate electrode, a drain electrode, and a source electrode. The first transistor ST1 may have the gate electrode connected to a first node N1, the drain electrode connected to the first voltage line VDL, and the source electrode connected to a second node N2. The first transistor ST1 may control a drain-source current (or driving current) based on a data voltage applied to the gate electrode.

The light emitting element ED may emit light in response to a driving current. The amount of light emitted from the light emitting element ED or the luminance of the light emitting element ED may be proportional to the magnitude of the driving current. The light emitting element ED may be an organic light emitting diode including an organic light emitting layer, a quantum dot light emitting diode including a quantum dot light emitting layer, a micro-light emitting diode, or an inorganic light emitting diode including an inorganic semiconductor.

A first electrode of the light emitting element ED may be connected to the second node N2, and a second electrode of the light emitting element ED may be connected to the vertical voltage line VVSL. The first electrode of the light emitting element ED may be connected to the source electrode of the first transistor ST1, a drain electrode of the third transistor ST3, and a second capacitor electrode of the first capacitor C1 through the second node N2.

The second transistor ST2 may be turned on by a gate signal of the gate line GL to electrically connect the data line DL and the first node N1 which is the gate electrode of the first transistor ST1. The second transistor ST2 may be turned on based on the gate signal to supply a data voltage to the first node N1. The second transistor ST2 may have a gate electrode connected to the gate line GL, a drain electrode connected to the data line DL, and a source electrode connected to the first node N1. The source electrode of the second transistor ST2 may be connected to the gate electrode of the first transistor ST1 and a first capacitor electrode of the first capacitor C1 through the first node N1.

The third transistor ST3 may be turned on by the gate signal of the gate line GL to electrically connect the initialization voltage line VIL and the second node N2 which is the source electrode of the first transistor ST1. The third transistor ST3 may be turned on based on the gate signal to supply an initialization voltage to the second node N2. The third transistor ST3 may be turned on based on the gate signal to supply a sensing signal to the initialization voltage line VIL. The third transistor ST3 may have a gate electrode connected to the gate line GL, the drain electrode connected to the second node N2, and a source electrode connected to the initialization voltage line VIL. The drain electrode of the third transistor ST3 may be connected to the source electrode of the first transistor ST1, the second capacitor electrode of the first capacitor C1, and the first electrode of the light emitting element ED through the second node N2.

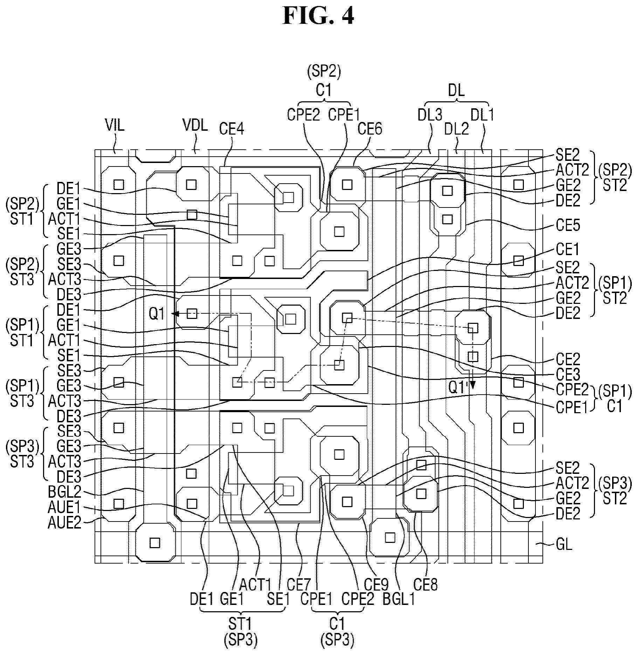

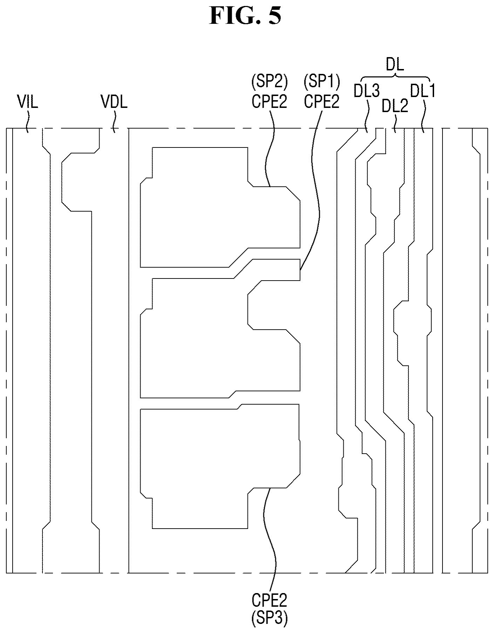

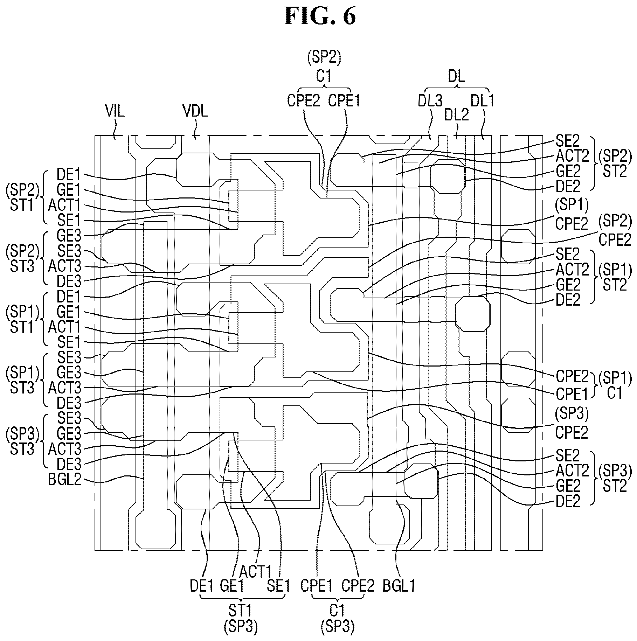

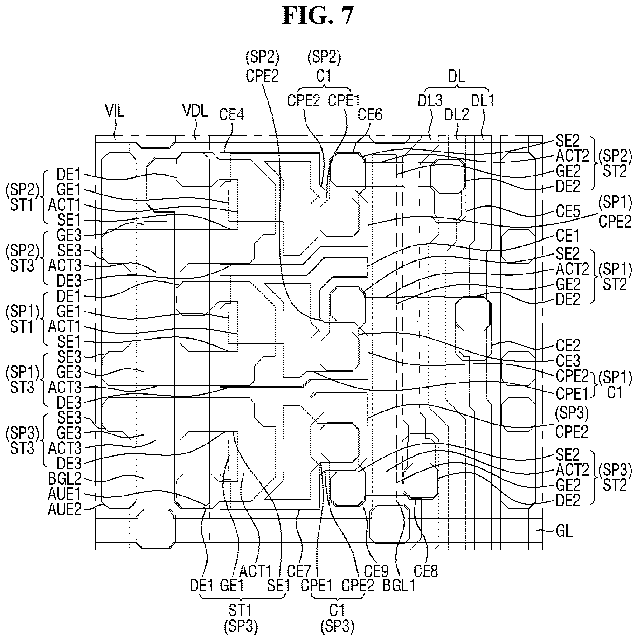

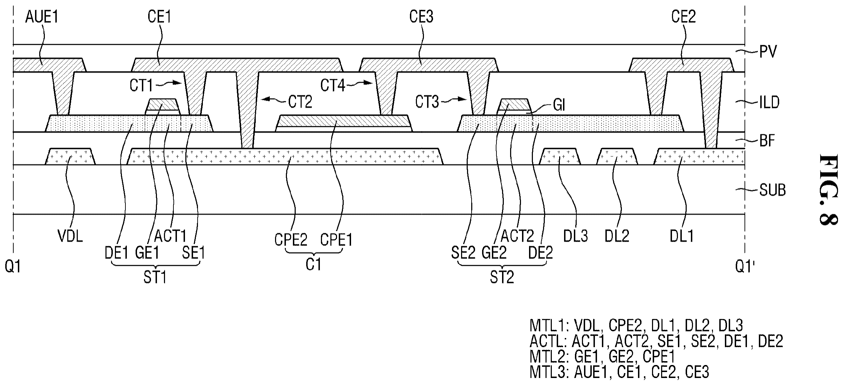

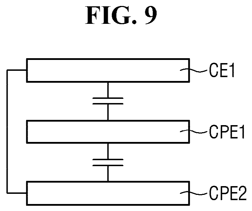

FIG. 4 is a plan view of a thin-film transistor layer of the display device according to the embodiment. FIG. 5 is a plan view of a first metal layer of the thin-film transistor layer of FIG. 4. FIG. 6 is a plan view of the first metal layer, an active layer and a second metal layer of the thin-film transistor layer of FIG. 4. FIG. 7 is a plan view of the first metal layer, the active layer, the second metal layer and a third metal layer of the thin-film transistor layer of FIG. 4. FIG. 8 is a cross-sectional view taken along line Q1-Q1' of FIG. 4. FIG. 9 is a diagram of a first capacitor of the thin-film transistor layer.

FIG. 8 illustrates the cross-sectional structure of a first transistor ST1, a first capacitor C1 and a second transistor ST2 of a first pixel SP1.

Referring to FIGS. 4 through 7, the display area DA may include first through third pixels SP1 through SP3, a first voltage line VDL, an initialization voltage line VIL, a gate line GL, first and second auxiliary gate lines BGL1 and BGL2, and data lines DL.

The pixels SP may include the first through third pixels SP1 through SP3. A pixel circuit of the second pixel SP2, a pixel circuit of the first pixel SP1, and a pixel circuit of the third pixel SP3 may be arranged in the direction opposite to the second direction (Y-axis direction), but the order of the pixel circuits is not limited thereto.

The first metal layer MTL1, the second metal layer MTL2, and the third metal layer MTL3 may be disposed on a substrate SUB. The first metal layer MTL1 may include the first voltage line VDL, second capacitor electrodes CPE2, first through third data lines DL1 through DL3, and the initialization voltage line VIL. The second metal layer MTL2 may include the first and second auxiliary gate lines BGL1 and BGL2 and first capacitor electrodes CPE1. The third metal layer MTL3 may include first through ninth connection patterns CE1 through CE9 and first and second auxiliary electrodes AUE1 and AUE2. The active layer ACTL may include active regions ACT1 through ACT3, source electrodes SE1 and drain electrodes DE1 of the first through third transistors ST1 through ST3 of each of the first through third pixels SP1 through SP3.

The first voltage line VDL may be disposed on left sides of the pixel circuits of the first through third pixels SP1 through SP3. The first voltage line VDL may overlap the first auxiliary electrode AUE1 of the third metal layer MTL3. The second metal layer MTL2 may be disposed on a gate insulating layer Gl covering the active layer ACTL, and the third metal layer MTL3 may be disposed on an interlayer insulating layer ILD covering the second metal layer MTL2. A passivation layer PV may cover the third metal layer MTL3. The first auxiliary electrode AUE1 may be connected to the first voltage line VDL through contact holes. The first voltage line VDL may be connected to the first auxiliary electrode AUE1 to reduce wiring resistance.

The first auxiliary electrode AUE1 may be connected to the drain electrode DE1 of the first transistor ST1 of each of the first through third pixels SP1 through SP3. Therefore, the first voltage line VDL may supply a driving voltage to each of the first through third pixels SP1 through SP3 through the first auxiliary electrode AUE1.

The initialization voltage line VIL may be disposed to a left side of the first voltage line VDL. The initialization voltage line VIL may overlap the second auxiliary electrode AUE2 of the third metal layer MTL3 and may be connected to the second auxiliary electrode AUE2 through contact holes. The initialization voltage line VIL may be connected to the second auxiliary electrode AUE2 to reduce wiring resistance.

The second auxiliary electrode AUE2 may be connected to the source electrode SE3 of the third transistor ST3 of each of the first through third pixels SP1 through SP3. Therefore, the initialization voltage line VIL may supply an initialization voltage to the third transistor ST3 of each of the first through third pixels SP1 through SP3 through the second auxiliary electrode AUE2 and may receive a sensing signal from the third transistor ST3.

The gate line GL may be disposed below the pixel circuit of the third pixel SP3. The gate line GL may be connected to the first and second auxiliary gate lines BGL1 and BGL2 and may supply a gate signal received from the gate drivers 260 to the first and second auxiliary gate lines BGL1 and BGL2.

The first auxiliary gate line BGL1 may protrude from the gate line GL in the second direction (Y-axis direction). The first auxiliary gate line BGL1 may be disposed on right sides of the pixel circuits of the first through third pixels SP1 through SP3. The first auxiliary gate line BGL1 may supply a gate signal received from the gate line GL to the second transistor ST2 of each of the first through third pixels SP1 through SP3.

The second auxiliary gate line BGL2 may protrude from the gate line GL2 in the second direction (Y-axis direction). The second auxiliary gate line BGL2 may be disposed between the initialization voltage line VIL and the first voltage line VDL. The second auxiliary gate line BGL2 may supply a gate signal received from the gate line GL to the third transistor ST3 of each of the first through third pixels SP1 through SP3.

The first data line DL1 may be disposed on a right side of the second data line DL2. The second connection pattern CE2 may electrically connect the first data line DL1 and the drain electrode DE2 of the second transistor ST2 of the first pixel SP1. Therefore, the first data line DL1 may supply a data voltage to the second transistor ST2 of the first pixel SP1 through the second connection pattern CE2.

The second data line DL2 may be disposed on a left side of the first data line DL1. The fifth connection pattern CE5 may electrically connect the second data line DL2 and the drain electrode DE2 of the second transistor ST2 of the second pixel SP2. Therefore, the second data line DL2 may supply a data voltage to the second transistor ST2 of the second pixel SP2 through the fifth connection pattern CE5.

The third data line DL3 may be disposed on a right side of the first auxiliary gate line BGL1. The eighth connection pattern CE8 may electrically connect the third data line DL3 and the drain electrode DE2 of the second transistor ST2 of the third pixel SP3. Therefore, the third data line DL3 may supply a data voltage to the second transistor ST2 of the third pixel SP3 through the eighth connection pattern CE8.

The pixel circuit of the first pixel SP1 may include the first through third transistors ST1 through ST3. The first transistor ST1 of the first pixel SP1 may include the active region ACT1, a gate electrode GE1, the drain electrode DE1, and the source electrode SE1. The active region ACT1 of the first transistor ST1 may overlap the gate electrode GE1 of the first transistor ST1. The active layer ACTL may be disposed on a buffer layer BF covering the first metal layer MTL1.

The gate electrode GE1 of the first transistor ST1 may be a portion of a first capacitor electrode CPE1 of the first capacitor C1. The drain electrode DE1 and the source electrode SE1 of the first transistor ST1 may be made conductive in an etching process of the gate electrode GE1. The drain electrode DE1 and the source electrode SE1 may be regions of the active layer which are imparted conductivity by converting the active layer ACTL to an N-type semiconductor, but the present disclosure is not limited thereto. The drain electrode DE1 of the first transistor ST1 may be electrically connected to the first voltage line VDL through the first auxiliary electrode AUE1. The drain electrode DE1 of the first transistor ST1 may receive a driving voltage from the first voltage line VDL.

The source electrode SE1 of the first transistor ST1 may be connected to the first connection pattern CE1. The first connection pattern CE1 may be connected to a second capacitor electrode CPE2. Therefore, the first capacitor C1 may be formed between the first capacitor electrode CPE1 and the second capacitor electrode CPE2 and between the first capacitor electrode CPE1 and the first connection pattern CE1.

The first connection pattern CE1 may be electrically connected to a light emitting element ED of the first pixel SP1. Therefore, the first connection pattern CE1 may supply a driving current received from the pixel circuit of the first pixel SP1 to the light emitting element ED.

The second transistor ST2 of the first pixel SP1 may include the active region ACT2, a gate electrode GE2, the drain electrode DE2, and the source electrode SE2. The active region ACT2 of the second transistor ST2 may overlap the gate electrode GE2 of the second transistor ST2.

The gate electrode GE2 of the second transistor ST2 may be a portion of the first auxiliary gate line BGL1. The drain electrode DE2 and the source electrode SE2 of the second transistor ST2 may be made conductive in an etching process of the gate electrode GE2. The drain electrode DE2 of the second transistor ST2 may be electrically connected to the first data line DL1 through the second connection pattern CE2. Therefore, the first data line DL1 may supply a data voltage to the second transistor ST2 of the first pixel SP1 through the second connection pattern CE2. The source electrode SE2 of the second transistor ST2 may be electrically connected to the first capacitor electrode CPE1 of the first capacitor C1 through the third connection pattern CE3.

The third transistor ST3 of the first pixel SP1 may include the active region ACT3, a gate electrode GE3, the drain electrode DE3, and the source electrode SE3. The active region ACT3 of the third transistor ST3 may overlap the gate electrode GE3 of the third transistor ST3.

The gate electrode GE3 of the third transistor ST3 may be a portion of the second auxiliary gate line BGL2. The drain electrode DE3 and the source electrode SE3 of the third transistor ST3 may be made conductive in an etching process of the gate electrode GE3. The drain electrode DE3 of the third transistor ST3 may be connected to an extension portion of the first connection pattern CE1. The drain electrode DE3 of the third transistor ST3 may be electrically connected to the source electrode SE1 of the first transistor ST1 and the second capacitor electrode CPE2 of the first capacitor C1 through the first connection pattern CE1.

The source electrode SE3 of the third transistor ST3 may be electrically connected to the initialization voltage line VIL through the second auxiliary electrode AUE2. The source electrode SE3 of the third transistor ST3 may receive an initialization voltage from the initialization voltage line VIL. The source electrode SE3 of the third transistor ST3 may supply a sensing signal to the initialization voltage line VIL.

The pixel circuit of the second pixel SP2 may include the first through third transistors ST1 through ST3. The first transistor ST1 of the second pixel SP2 may include the active region ACT1, a gate electrode GE1, the drain electrode DE1, and the source electrode SE1. The active region ACT1 of the first transistor ST1 may overlap the gate electrode GE1 of the first transistor ST1.

The gate electrode GE1 of the first transistor ST1 may be a portion of a first capacitor electrode CPE1 of a first capacitor C1. The drain electrode DE1 and the source electrode SE1 of the first transistor ST1 may be made conductive in an etching process of the gate electrode GE1. The drain electrode DE1 and the source electrode SE1 may be made conductive using an N-type semiconductor, but the present disclosure not limited thereto. The drain electrode DE1 of the first transistor ST1 may be electrically connected to the first voltage line VDL through the first auxiliary electrode AUE1. The drain electrode DE1 of the first transistor ST1 may receive a driving voltage from the first voltage line VDL.

The source electrode SE1 of the first transistor ST1 may be connected to the fourth connection pattern CE4. The fourth connection pattern CE4 may be connected to a second capacitor electrode CPE2. Therefore, the first capacitor C1 may be formed between the first capacitor electrode CPE1 and the second capacitor electrode CPE2 and between the first capacitor electrode CPE1 and the fourth connection pattern CE4.

The fourth connection pattern CE4 may be electrically connected to a light emitting element ED of the second pixel SP2. Therefore, the fourth connection pattern CE4 may supply a driving current received from the pixel circuit of the second pixel SP2 to the light emitting element ED.

The second transistor ST2 of the second pixel SP2 may include the active region ACT2, a gate electrode GE2, the drain electrode DE2, and the source electrode SE2. The active region ACT2 of the second transistor ST2 may overlap the gate electrode GE2 of the second transistor ST2.

The gate electrode GE2 of the second transistor ST2 may be a portion of the first auxiliary gate line BGL1. The drain electrode DE2 and the source electrode SE2 of the second transistor ST2 may be made conductive in an etching process of the gate electrode GE2. The drain electrode DE2 of the second transistor ST2 may be electrically connected to the second data line DL2 through the fifth connection pattern CE5. Therefore, the second data line DL2 may supply a data voltage to the second transistor ST2 of the second pixel SP2 through the fifth connection pattern CE5. The source electrode SE2 of the second transistor ST2 may be electrically connected to the first capacitor electrode CPE1 of the first capacitor C1 through the sixth connection pattern CE6.

The third transistor ST3 of the second pixel SP2 may include the active region ACT3, a gate electrode GE3, the drain electrode DE3, and the source electrode SE3. The active region ACT3 of the third transistor ST3 may overlap the gate electrode GE3 of the third transistor ST3.

The gate electrode GE3 of the third transistor ST3 may be a portion of the second auxiliary gate line BGL2. The drain electrode DE3 and the source electrode SE3 of the third transistor ST3 may be made conductive in an etching process of the gate electrode GE3. The drain electrode DE3 of the third transistor ST3 may be connected to an extension portion of the fourth connection pattern CE4. The drain electrode DE3 of the third transistor ST3 may be electrically connected to the source electrode SE1 of the first transistor ST1 and the second capacitor electrode CPE2 of the first capacitor C1 through the fourth connection pattern CE4.

The source electrode SE3 of the third transistor ST3 may be electrically connected to the initialization voltage line VIL through the second auxiliary electrode AUE2. The source electrode SE3 of the third transistor ST3 may receive an initialization voltage from the initialization voltage line VIL. The source electrode SE3 of the third transistor ST3 may supply a sensing signal to the initialization voltage line VIL.

The pixel circuit of the third pixel SP3 may include the first through third transistors ST1 through ST3. The first transistor ST1 of the third pixel SP3 may include the active region ACT1, a gate electrode GE1, the drain electrode DE1, and the source electrode SE1. The active region ACT1 of the first transistor ST1 may overlap the gate electrode GE1 of the first transistor ST1.

The gate electrode GE1 of the first transistor ST1 may be a portion of a first capacitor electrode CPE1 of a first capacitor C1. The drain electrode DE1 and the source electrode SE1 of the first transistor ST1 may be made conductive in an etching process of the gate electrode GE1. The drain electrode DE1 and the source electrode SE1 may be made conductive using an N-type semiconductor, but the present disclosure is not limited thereto. The drain electrode DE1 of the first transistor ST1 may be electrically connected to the first voltage line VDL through the first auxiliary electrode AUE1. The drain electrode DE1 of the first transistor ST1 may receive a driving voltage from the first voltage line VDL.

The source electrode SE1 of the first transistor ST1 may be connected to the seventh connection pattern CE7. The seventh connection pattern CE7 may be connected to a second capacitor electrode CPE2. Therefore, the first capacitor C1 may be formed between the first capacitor electrode CPE1 and the second capacitor electrode CPE2 and between the first capacitor electrode CPE1 and the seventh connection pattern CE7.

The seventh connection pattern CE7 may be electrically connected to a light emitting element ED of the third pixel SP3. Therefore, the seventh connection pattern CE7 may supply a driving current received from the pixel circuit of the third pixel SP3 to the light emitting element ED.

The second transistor ST2 of the third pixel SP3 may include the active region ACT2, a gate electrode GE2, the drain electrode DE2, and the source electrode SE2. The active region ACT2 of the second transistor ST2 may overlap the gate electrode GE2 of the second transistor ST2.

The gate electrode GE2 of the second transistor ST2 may be a portion of the first auxiliary gate line BGL1. The drain electrode DE2 and the source electrode SE2 of the second transistor ST2 may be made conductive in an etching process of the gate electrode GE2. The drain electrode DE2 of the second transistor ST2 may be electrically connected to the third data line DL3 through the eighth connection pattern CE8. Therefore, the third data line DL3 may supply a data voltage to the second transistor ST2 of the third pixel SP3 through the eighth connection pattern CE8. The source electrode SE2 of the second transistor ST2 may be electrically connected to the first capacitor electrode CPE1 of the first capacitor C1 through the ninth connection pattern CE9.

The third transistor ST3 of the third pixel SP3 may include the active region ACT3, a gate electrode GE3, the drain electrode DE3, and the source electrode SE3. The active region ACT3 of the third transistor ST3 may overlap the gate electrode GE3 of the third transistor ST3.

The gate electrode GE3 of the third transistor ST3 may be a portion of the second auxiliary gate line BGL2. The drain electrode DE3 and the source electrode SE3 of the third transistor ST3 may be made conductive in an etching process of the gate electrode GE3. The drain electrode DE3 of the third transistor ST3 may be connected to a second extension portion of the seventh connection pattern CE7. The drain electrode DE3 of the third transistor ST3 may be electrically connected to the source electrode SE1 of the first transistor ST1 and the second capacitor electrode CPE2 of the first capacitor C1 through the seventh connection pattern CE7.

The source electrode SE3 of the third transistor ST3 may be electrically connected to the initialization voltage line VIL through the second auxiliary electrode AUE2. The source electrode SE3 of the third transistor ST3 may receive an initialization voltage from the initialization voltage line VIL. The source electrode SE3 of the third transistor ST3 may supply a sensing signal to the initialization voltage line VIL.

Referring to FIGS. 8 and 9, the first capacitor C1 may be formed between the first capacitor electrode CPE1 and the second capacitor electrode CPE2 and between the first capacitor electrode CPE1 and the first connection pattern CE1.

Specifically, the source electrode SE1 of the first transistor ST1 may be connected to the first connection pattern CE1. The first connection pattern CE1 may be connected to the source electrode SE1 of the first transistor ST1 through a first contact hole CT1 penetrating the interlayer insulating layer ILD. The first connection pattern CE1 may be connected to the second capacitor electrode CPE2. The first connection pattern CE1 may be connected to the second capacitor electrode CPE2 through a second contact hole CT2 penetrating the buffer layer BF and the interlayer insulating layer ILD.

The source electrode SE2 of the second transistor ST2 may be connected to the third connection pattern CE3. The third connection pattern CE3 may be connected to the source electrode SE2 of the second transistor ST2 through a third contact hole CT3 penetrating the interlayer insulating layer ILD. The third connection pattern CE3 may be connected to the first capacitor electrode CPE1. The third connection pattern CE3 may be connected to the first capacitor electrode CPE1 through a fourth contact hole CT4 penetrating the interlayer insulating layer ILD.

The second capacitor electrode CPE2, the first capacitor electrode CPE1, and the first connection pattern CE1 described above may overlap each other. Therefore, the first capacitor C1 may be formed between the first capacitor electrode CPE1 and the second capacitor electrode CPE2 and between the first capacitor electrode CPE1 and the first connection pattern CE1.

The second capacitor electrode CPE2 may overlap the fourth contact hole CT4 connected to the third connection pattern CE3 and the first capacitor electrode CPE1. That is, the second capacitor electrode CPE2 may overlap the first capacitor electrode CPE1 overlapping the fourth contact hole CT4 in a plan view, thereby increasing the capacitance of the first capacitor C1.

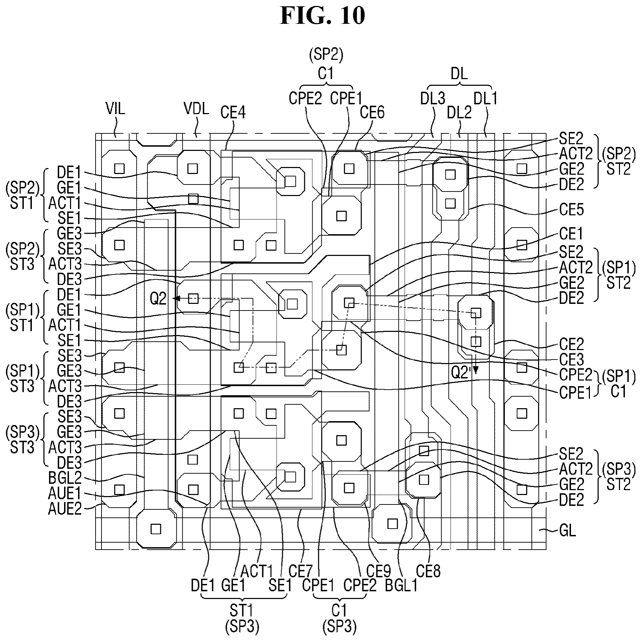

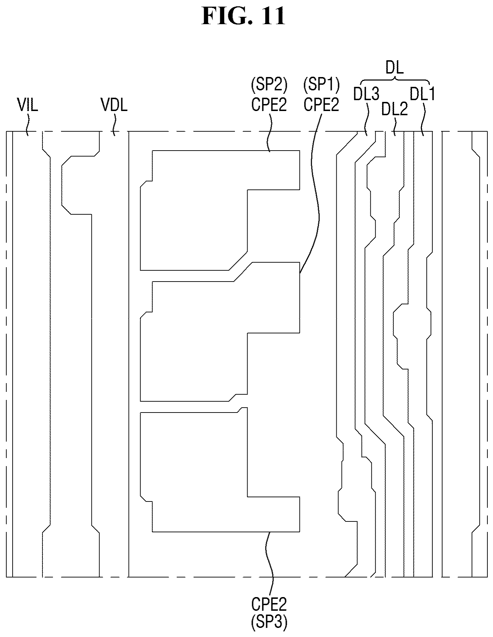

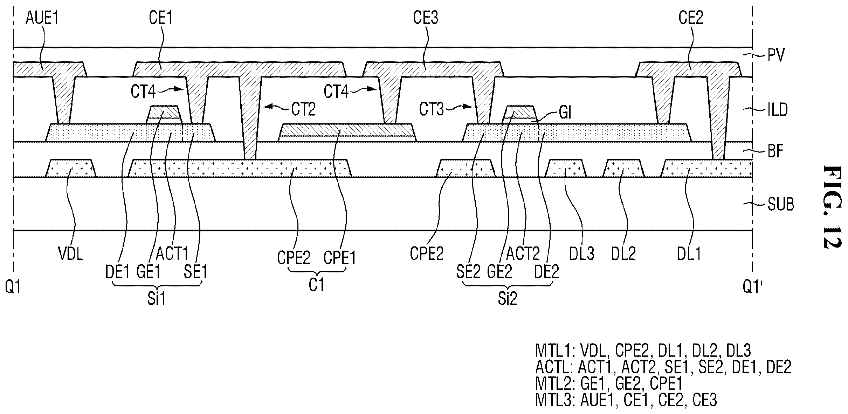

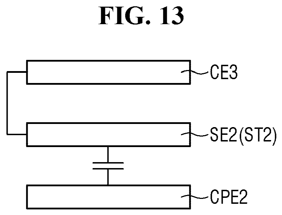

FIG. 10 is a plan view of a thin-film transistor layer of a display device according to an embodiment. FIG. 11 is a plan view of a first metal layer of the thin-film transistor layer of FIG. 10. FIG. 12 is a cross-sectional view taken along line Q2-Q2' of FIG. 10. FIG. 13 is a diagram of a first capacitor of the thin-film transistor layer.

Referring to FIGS. 10 through 13, the current embodiment is different from the embodiment of FIGS. 4 through 9 in that a second capacitor electrode CPE2 overlaps a third contact hole CT3. A description of the same elements and features as those of the above-described embodiment will be omitted below, and differences will be described.

The second capacitor electrode CPE2 of the first metal layer MTL1 may be disposed on a substrate SUB. The second capacitor electrode CPE2 may extend from under a first transistor ST1 to under a second transistor ST2. For example, the second capacitor electrode CPE2 may overlap a gate electrode GE1 and a source electrode SE1 of the first transistor ST1 and a source electrode SE2 of the second transistor ST2. In addition, the second capacitor electrode CPE2 may overlap a first connection pattern CE1 and a third connection pattern CE3 of a third metal layer MTL3.

A first capacitor C1 may be formed between a first capacitor electrode CPE1 and the second capacitor electrode CPE2, between the first capacitor electrode CPE1 and the first connection pattern CE1, and between the second capacitor electrode CPE2 and the source electrode SE2 of the second transistor ST2.

Specifically, the source electrode SE1 of the first transistor ST1 may be connected to the first connection pattern CE1. The first connection pattern CE1 may be connected to the source electrode SE1 of the first transistor ST1 through a first contact hole CT1 penetrating an interlayer insulating layer ILD. The first connection pattern CE1 may be connected to the second capacitor electrode CPE2. The first connection pattern CE1 may be connected to the second capacitor electrode CPE2 through a second contact hole CT2 penetrating a buffer layer BF and the interlayer insulating layer ILD.

The source electrode SE2 of the second transistor ST2 may be connected to the third connection pattern CE3. The third connection pattern CE3 may be connected to the source electrode SE2 of the second transistor ST2 through the third contact hole CT3 penetrating the interlayer insulating layer ILD. The third connection pattern CE3 may be connected to the first capacitor electrode CPE1. The third connection pattern CE3 may be connected to the first capacitor electrode CPE1 through a fourth contact hole CT4 penetrating the interlayer insulating layer ILD.

The second capacitor electrode CPE2, the first capacitor electrode CPE1, and the first connection pattern CE1 described above may overlap each other. Therefore, the first capacitor C1 may be formed between the first capacitor electrode CPE1 and the second capacitor electrode CPE2 and between the first capacitor electrode CPE1 and the first connection pattern CE1.

The second capacitor electrode CPE2 may overlap the third contact hole CT3 overlapping the third connection pattern CE3. In addition, the second capacitor electrode CPE2 may overlap the third contact hole CT3 exposing the source electrode SE2 of the second transistor ST2. Specifically, the second capacitor electrode CPE2 may not overlap the fourth contact hole CT4 connected to the third connection pattern CE3 and the first capacitor electrode CPE1 and may overlap the third contact hole CT3 connected to the third connection pattern CE3 and the source electrode SE2 of the second transistor ST2.

The second capacitor electrode CPE2 may overlap the source electrode SE2 of the second transistor ST2. The second capacitor electrode CPE2 may not overlap a gate electrode GE2 of the second transistor ST2. The source electrode SE2 of the second transistor ST2 may be made conductive to function as a conductive layer. Accordingly, the second capacitor electrode CPE2 may function as a lower electrode of the first capacitor C1, and the source electrode SE2 of the second transistor ST2 may function as an upper electrode of the first capacitor C1.

In the current embodiment, since the second capacitor electrode CPE2 further forms a capacitor with the source electrode SE2 of the second transistor ST2, the capacitance of the first capacitor C1 can be increased.

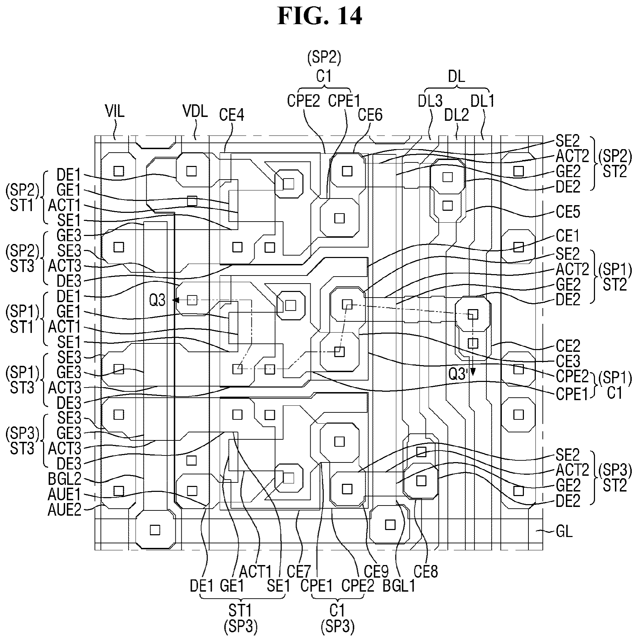

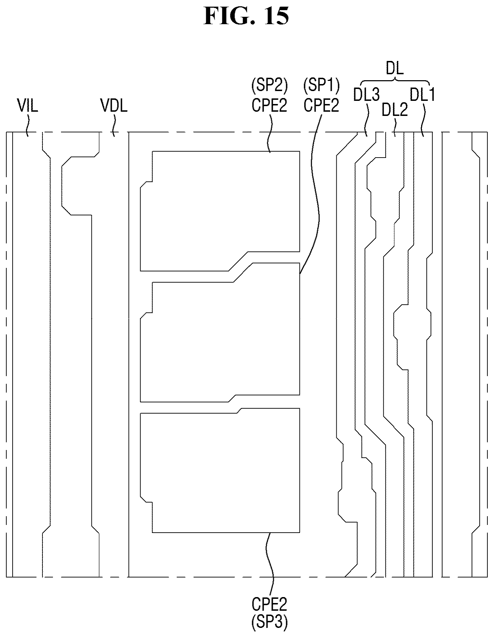

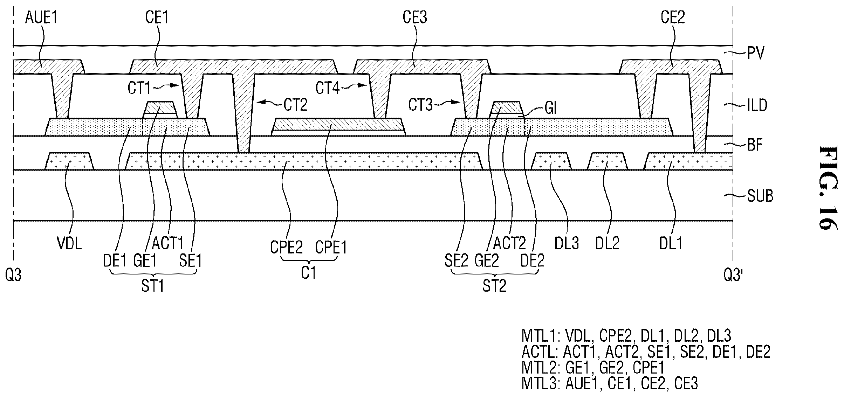

FIG. 14 is a plan view of a thin-film transistor layer of a display device according to an embodiment. FIG. 15 is a plan view of a first metal layer of the thin-film transistor layer of FIG. 14. FIG. 16 is a cross-sectional view taken along line Q3-Q3' of FIG. 14.

Referring to FIGS. 14 through 16, the current embodiment is different from the embodiments of FIGS. 4 through 13 in that a second capacitor electrode CPE2 is extended to overlap third and fourth contact holes CT3 and CT4. A description of the same elements and features as those of the above-described embodiments will be omitted below, and differences will be described.

The second capacitor electrode CPE2 of the first metal layer MTL1 may be disposed on a substrate SUB. The second capacitor electrode CPE2 may extend from under a first transistor ST1 to under a second transistor ST2. For example, the second capacitor electrode CPE2 may overlap a gate electrode GE1 and a source electrode SE1 of the first transistor ST1 and a source electrode SE2 of the second transistor ST2. In addition, the second capacitor electrode CPE2 may overlap a first connection pattern CE1 and a third connection pattern CE3 of a third metal layer MTL3.

A first capacitor C1 may be formed between a first capacitor electrode CPE1 and the second capacitor electrode CPE2, between the first capacitor electrode CPE1 and the first connection pattern CE1, and between the second capacitor electrode CPE2 and the source electrode SE2 of the second transistor ST2.

Specifically, the source electrode SE1 of the first transistor ST1 may be connected to the first connection pattern CE1. The first connection pattern CE1 may be connected to the source electrode SE1 of the first transistor ST1 through a first contact hole CT1 penetrating an interlayer insulating layer ILD. The first connection pattern CE1 may be connected to the second capacitor electrode CPE2. The first connection pattern CE1 may be connected to the second capacitor electrode CPE2 through a second contact hole CT2 penetrating a buffer layer BF and the interlayer insulating layer ILD.

The source electrode SE2 of the second transistor ST2 may be connected to the third connection pattern CE3. The third connection pattern CE3 may be connected to the source electrode SE2 of the second transistor ST2 through the third contact hole CT3 penetrating the interlayer insulating layer ILD. The third connection pattern CE3 may be connected to the first capacitor electrode CPE1. The third connection pattern CE3 may be connected to the first capacitor electrode CPE1 through the fourth contact hole CT4 penetrating the interlayer insulating layer ILD.

The second capacitor electrode CPE2, the first capacitor electrode CPE1, and the first connection pattern CE1 described above may overlap each other. Therefore, the first capacitor C1 may be formed between the first capacitor electrode CPE1 and the second capacitor electrode CPE2 and between the first capacitor electrode CPE1 and the first connection pattern CE1.

The second capacitor electrode CPE2 may overlap the third contact hole CT3 and the fourth contact hole CT4 overlapping the third connection pattern CE3. The second capacitor electrode CPE2 may overlap the third contact hole CT3 and the fourth contact hole CT4 respectively exposing the second source electrode SE2 of the second transistor ST2 and the first capacitor electrode CPE1. Specifically, the second capacitor electrode CPE2 may overlap the fourth contact hole CT4 exposing the first capacitor electrode CPE1 and may overlap the third contact hole CT3 exposing the source electrode SE2 of the second transistor ST2. The third connection pattern CE3 may connect the first capacitor electrode CPE1 and the source electrode SE2 of the second transistor ST2 through the third contact hole CT3 and the fourth contact hole CT4.

In the current embodiment, the second capacitor electrode CPE2 may be extended to overlap the fourth contact hole CT4 and increase an overlap area with the first capacitor electrode CPE1, thereby increasing the capacitance of the first capacitor C1. In addition, since the second capacitor electrode CPE2 further forms a capacitor with the source electrode SE2 of the second transistor ST2, the capacitance of the first capacitor C1 can be further increased.

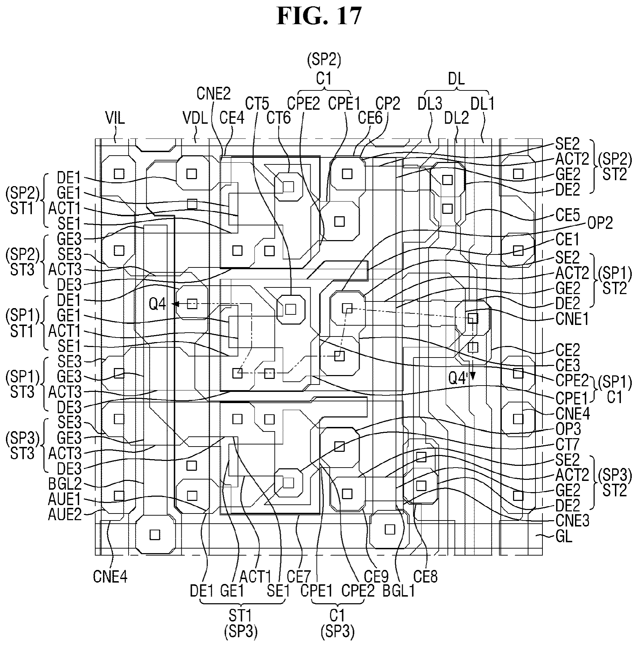

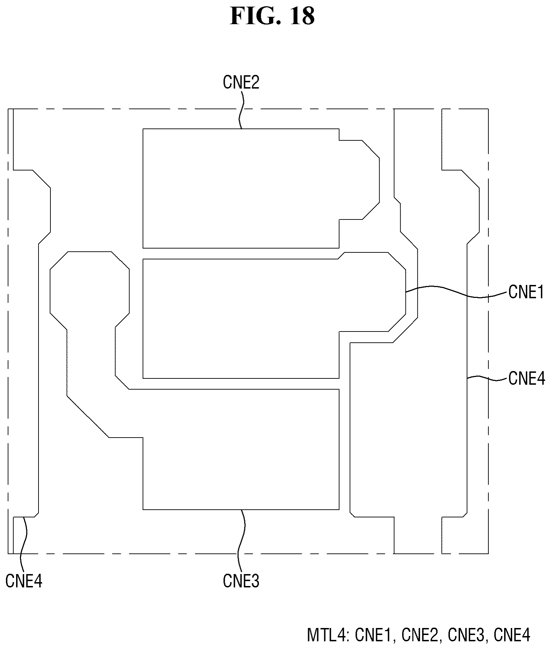

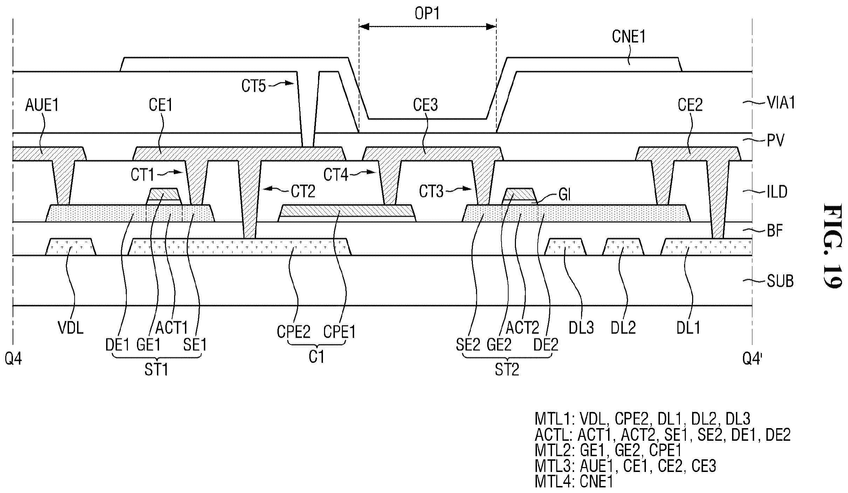

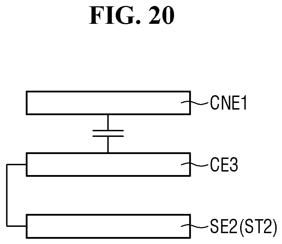

FIG. 17 is a plan view of a thin-film transistor layer of a display device according to an embodiment. FIG. 18 is a plan view of a fourth metal layer of the thin-film transistor layer of FIG. 17. FIG. 19 is a cross-sectional view taken along line Q4-Q4' of FIG. 14. FIG. 20 is a diagram of a first capacitor of the thin-film transistor layer.

Referring to FIGS. 17 through 20, the current embodiment is different from the embodiments of FIGS. 4 through 16 in that the thin-film transistor layer further includes a first via layer VIA1 and the fourth metal layer MTL4 and that the first via layer VIA1 includes first through third openings OP1 through OP3. A description of the same elements and features as those of the above-described embodiments will be omitted below, and differences will be described.

A second capacitor electrode CPE2 may overlap a first capacitor electrode CPE1 but may not overlap a third connection pattern CE3. The second capacitor electrode CPE2 may not overlap a fourth contact hole CT4 through which the third connection pattern CE3 and the first capacitor electrode CPE1 are connected. The second capacitor electrode CPE2 may not overlap a third contact hole CT3 through which the third connection pattern CE3 and a source electrode SE2 of a second transistor ST2 are connected.

The thin-film transistor layer may further include the first via layer VIA1 and the fourth metal layer MTL4. The first via layer VIA1 may be disposed on a passivation layer PV to flatten a step thereunder.

The fourth metal layer MTL4 may be disposed on the first via layer VIA1. The fourth metal layer MTL4 may include first through fourth connection electrodes CNE1 through CNE4. The first connection electrode CNE1 may be disposed in a first pixel SP1 and may overlap first through third transistors ST1 through ST3 of the first pixel SP1. The first connection electrode CNE1 may overlap a first connection pattern CE1 and may be connected to the first connection pattern CE1 through a fifth contact hole CT5 penetrating the passivation layer PV and the first via layer VIA1. The second connection electrode CNE2 may be disposed in a second pixel SP2 and may overlap first through third transistors ST1 through ST3 of the second pixel SP2. The second connection electrode CNE2 may overlap a fourth connection pattern CE4 and may be connected to the fourth connection pattern CE4 through a sixth contact hole CT6 penetrating the passivation layer PV and the first via layer VIA1. The third connection electrode CNE3 may be disposed in a third pixel SP3 and may overlap first through third transistors ST1 through ST3 of the third pixel SP3. The third connection electrode CNE3 may overlap a seventh connection pattern CE7 and may be connected to the seventh connection pattern CE7 through a seventh contact hole CT7 penetrating the passivation layer PV and the first via layer VIA1. The fourth connection electrode CNE4 may overlap an initialization voltage line VIL and data lines DL and extend parallel to the initialization voltage line VIL.

The first connection electrode CNE1 may overlap the third connection pattern CE3 to form a capacitor. For example, the first connection electrode CNE1 may function as an upper electrode of the capacitor, and the third connection pattern CE3 may function as a lower electrode of the capacitor. Accordingly, the first connection electrode CNE1 and the third connection pattern CE3 may form the capacitor.

In an embodiment, the first via layer VIA1 may include the first through third openings OP1 through OP3. The first opening OP1 may overlap the third connection pattern CE3 of the first pixel SP1, the second opening OP2 may overlap a sixth connection pattern CE6 of the second pixel SP2, and the third opening OP3 may overlap a ninth connection pattern CE9 of the third pixel SP3. Planar shapes and sizes of the first through third openings OP1 through OP3 may be the same as the shapes and sizes of the third connection pattern CE3, the sixth connection pattern CE6, and the ninth connection pattern CE9, respectively. However, the present disclosure is not limited thereto, and the planar sizes of the first through third openings OP1 through OP3 may also be larger than the planar sizes of the third connection pattern CE3, the sixth connection pattern CE6, and the ninth connection pattern CE9.

Taking the first opening OP1 of the first pixel SP1 as an example, the first opening OP1 may expose the passivation layer PV thereunder. However, the present disclosure is not limited thereto, and the first opening OP1 may also be an area in which the first via layer VIA1 is partially removed not to expose the passivation layer PV disposed thereunder. The first opening OP1 may overlap the third and fourth contact holes CT3 and CT4. The first connection electrode CNE1 of the fourth metal layer MTL4 may extend from an upper surface of the first via layer VIA1 to the passivation layer PV exposed through the first opening OP1 and may directly contact the passivation layer PV.

In an area where the first opening OP1 of the first via layer VIA1 is disposed, a structure in which the third connection pattern CE3, the passivation layer PV, and the first connection electrode CNE1 are sequentially stacked may be formed. That is, the first via layer VIA1 between the third connection pattern CE3 and the first connection electrode CNE1 may be removed. Accordingly, since the first via layer VIA1 is removed, only the passivation layer PV may be disposed between the third connection pattern CE3 and the first connection electrode CNE1, thereby increasing the capacitance of a capacitor formed by the third connection pattern CE3 and the first connection electrode CNE1. In addition, the capacitance of a capacitor between the sixth connection pattern CE6 and the second connection electrode CNE2 of the second pixel SP2 and the capacitance of a capacitor between the ninth connection pattern CE9 and the third connection electrode CNE3 of the third pixel SP3 may be increased.

In the current embodiment, the first opening OP1 of the first via layer VIA1 overlaps the whole of the third connection pattern CE3, but the present disclosure is not limited thereto. In some embodiments, the first opening OP1 of the first via layer VIA1 may overlap a portion of the third connection pattern CE3 overlapping the fourth contact hole CT4 or may overlap another portion of the third connection pattern CE3 overlapping the third contact hole CT3.

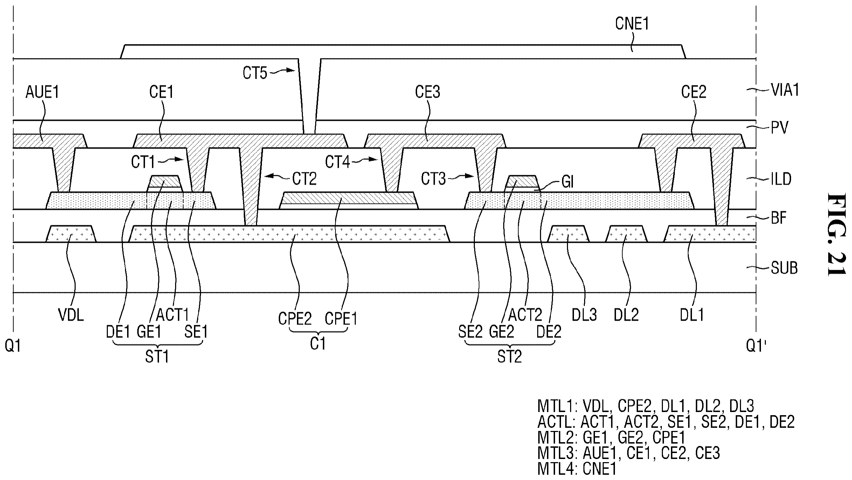

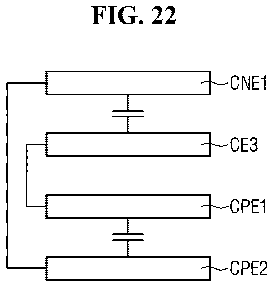

FIG. 21 is a cross-sectional view of a thin-film transistor layer of a display device according to an embodiment. FIG. 22 is a diagram of a first capacitor of the thin-film transistor layer. FIG. 21 illustrates a structure cut through the same portion as that of FIG. 8 described above.

Referring to FIGS. 21 and 22, the current embodiment is different from the embodiment of FIG. 8 in that the thin-film transistor layer further includes a first via layer VIA1 and a fourth metal layer MTL4. Structures of the first via layer VIA1 and the fourth metal layer MTL4 may correspond to structures in a case where first through third openings OP1 through OP3 are not formed in FIGS. 17 and 19 described above.

The first via layer VIA1 may be entirely disposed on a passivation layer PV. A first connection electrode CNE1 of the fourth metal layer MTL4 may be disposed on the first via layer VIA1 and may be connected to a first connection pattern CE1 through a fifth contact hole CT5 penetrating the passivation layer PV and the first via layer VIA1.

In the current embodiment, the first connection electrode CNE1 of the fourth metal layer MTL4 may be further formed to form a capacitor with a third connection pattern CE3 overlapping the first connection electrode CNE1. For example, the first connection electrode CNE1 may function as an upper electrode of the capacitor, and the third connection pattern CE3 may function as a lower electrode of the capacitor. Accordingly, the first connection electrode CNE1 and the third connection pattern CE3 may form the capacitor.

A first capacitor C1 of a first pixel SP1 may be formed not only between a first capacitor electrode CPE1 and a second capacitor electrode CPE2 and between the first capacitor electrode CPE1 and the first connection pattern CE1 but also between the first connection electrode CNE1 and the third connection pattern CE3. Therefore, the capacitance of the first capacitor C1 of each pixel SP1, SP2 or SP3 can be increased.

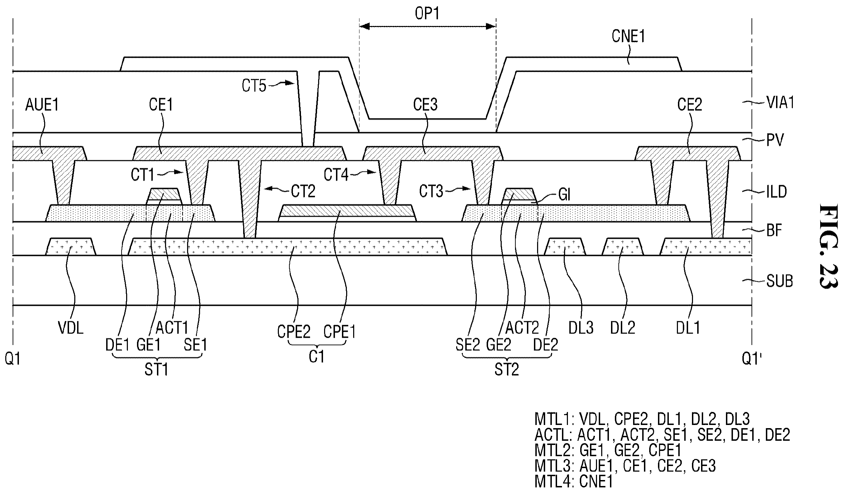

FIG. 23 is a cross-sectional view of a thin-film transistor layer of a display device according to an embodiment. FIG. 23 illustrates a structure cut through the same portion as that of FIG. 8 described above.

Referring to FIG. 23, the current embodiment is different from the embodiment of FIG. 8 in that the thin-film transistor layer further includes a first via layer VIA1 and a fourth metal layer MTL4. Since the arrangement of first through third openings OP1 through OP3 of the first via layer VIA1 and the fourth metal layer MTL4 is the same as that of FIGS. 17 through 20 described above, the current embodiment will be described using the first opening OP1 as an example.

Specifically, a second capacitor electrode CPE2 may overlap a portion of a third connection pattern CE3. For example, the second capacitor electrode CPE2 may overlap a fourth contact hole CT4 through which the third connection pattern CE3 and a first capacitor electrode CPE1 are connected. The second capacitor electrode CPE2 may not overlap a third contact hole CT3 through which the third connection pattern CE3 and a source electrode SE2 of a second transistor ST2 are connected.

The first via layer VIA1 may include the first opening OP1 overlapping the third connection pattern CE3. The first opening OP1 may overlap the third and fourth contact holes CT3 and CT4. A first connection electrode CNE1 of the fourth metal layer MTL4 may directly contact a passivation layer PV exposed through the first opening OP1.

A first capacitor C1 of a first pixel SP1 may be formed not only between the first capacitor electrode CPE1 and the second capacitor electrode CPE2 and between the first capacitor electrode CPE1 and a first connection pattern CE1 but also between the first connection electrode CNE1 and the third connection pattern CE3. Therefore, the capacitance of the first capacitor C1 of each pixel SP1, SP2 or SP3 can be increased.

In addition, since the first via layer VIA1 is removed from an area where the first opening OP1 of the first via layer VIA1 is disposed, only the passivation layer PV may be disposed between the third connection pattern CE3 and the first connection electrode CNE1, thereby further increasing the capacitance of a capacitor formed by the third connection pattern CE3 and the first connection electrode CNE1.

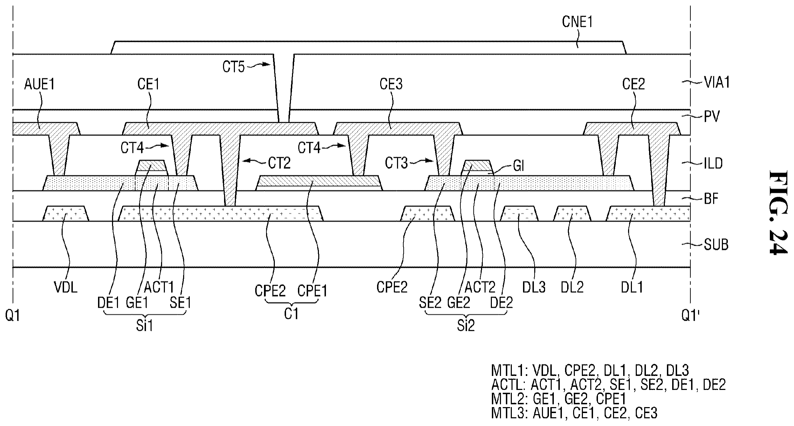

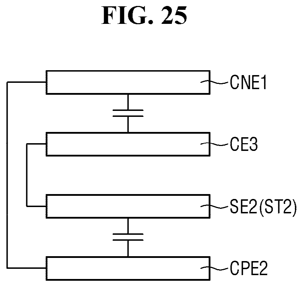

FIG. 24 is a cross-sectional view of a thin-film transistor layer of a display device according to an embodiment. FIG. 25 is a diagram of a capacitor in an area where a third contact hole CT3 is disposed. FIG. 24 illustrates a structure cut through the same portion as that of FIG. 12 described above.

Referring to FIGS. 24 and 25, the current embodiment is different from the embodiment of FIG. 13 in that the thin-film transistor layer further includes a first via layer VIA1 and a fourth metal layer MTL4. Structures of the first via layer VIA1 and the fourth metal layer MTL4 may correspond to the structures of FIG. 21 described above.

A second capacitor electrode CPE2 may extend from under a first transistor ST1 to under a second transistor ST2. For example, the second capacitor electrode CPE2 may overlap a gate electrode GE1 and a source electrode SE1 of the first transistor ST1 and a source electrode SE2 of the second transistor ST2. In addition, the second capacitor electrode CPE2 may overlap a first connection pattern CE1 and a third connection pattern CE3 of a third metal layer MTL3.

The second capacitor electrode CPE2 may overlap the third contact hole CT3 overlapping the third connection pattern CE3. The second capacitor electrode CPE2 may overlap the third contact hole CT3 exposing the second source electrode SE2 of the second transistor ST2. Specifically, the second capacitor electrode CPE2 may not overlap a fourth contact hole CT4 connected to the third connection pattern CE3 and a first capacitor electrode CPE1 and may overlap the third contact hole CT3 connected to the third connection pattern CE3 and the source electrode SE2 of the second transistor ST2.

A first capacitor C1 may be formed between the first capacitor electrode CPE1 and the second capacitor electrode CPE2, between the first capacitor electrode CPE1 and the first connection pattern CE1, and between the second capacitor electrode CPE2 and the source electrode SE2 of the second transistor ST2.

The first via layer VIA1 may be entirely disposed on a passivation layer PV. A first connection electrode CNE1 of the fourth metal layer MTL4 may be disposed on the first via layer VIA1 and may be connected to the first connection pattern CE1 through a fifth contact hole CT5 penetrating the passivation layer PV and the first via layer VIA1.

In the current embodiment, the first connection electrode CNE1 of the fourth metal layer MTL4 may be further formed to form a capacitor with the third connection pattern CE3 overlapping the first connection electrode CNE1. For example, the first connection electrode CNE1 may function as an upper electrode of the capacitor, and the third connection pattern CE3 may function as a lower electrode of the capacitor. Accordingly, the first connection electrode CNE1 and the third connection pattern CE3 may form the capacitor.

The first capacitor C1 of a first pixel SP1 may be formed between the first capacitor electrode CPE1 and the second capacitor electrode CPE2, between the first capacitor electrode CPE1 and the first connection pattern CE1, between the second capacitor electrode CPE2 and the source electrode SE2 of the second transistor ST2, and between the first connection electrode CNE1 and the third connection pattern CE3. Therefore, the capacitance of the first capacitor C1 of each pixel SP1, SP2 or SP3 can be increased.

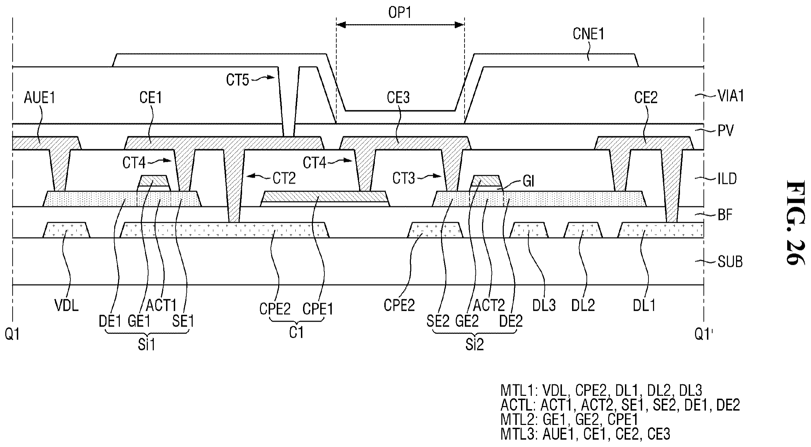

FIG. 26 is a cross-sectional view of a thin-film transistor layer of a display device according to an embodiment. FIG. 26 illustrates a structure cut through the same portion as that of FIG. 24 described above.

Referring to FIG. 26, the current embodiment is different from the embodiment of FIG. 24 in that a first via layer VIA1 of the thin-film transistor layer includes first through third openings OP1 through OP3. Since the arrangement of the first through third openings OP1 through OP3 is the same as that of FIGS. 17 through 20 described above, the current embodiment will be described using the first opening OP1 as an example.

The first via layer VIA1 may include the first opening OP1 overlapping a third connection pattern CE3. The first opening OP1 may expose a passivation layer PV thereunder. The first opening OP1 may overlap third and fourth contact holes CT3 and CT4. A first connection electrode CNE1 of a fourth metal layer MTL4 may directly contact the passivation layer PV exposed through the first opening OP1.

In an area where the first opening OP1 of the first via layer VIA1 is disposed, a structure in which the third connection pattern CE3, the passivation layer PV, and the first connection electrode CNE1 are sequentially stacked may be formed. Since the first via layer VIA1 is removed from the area where the first opening OP1 of the first via layer VIA1 is disposed, only the passivation layer PV may be disposed between the third connection pattern CE3 and the first connection electrode CNE1, thereby further increasing the capacitance of a capacitor formed by the third connection pattern CE3 and the first connection electrode CNE1.

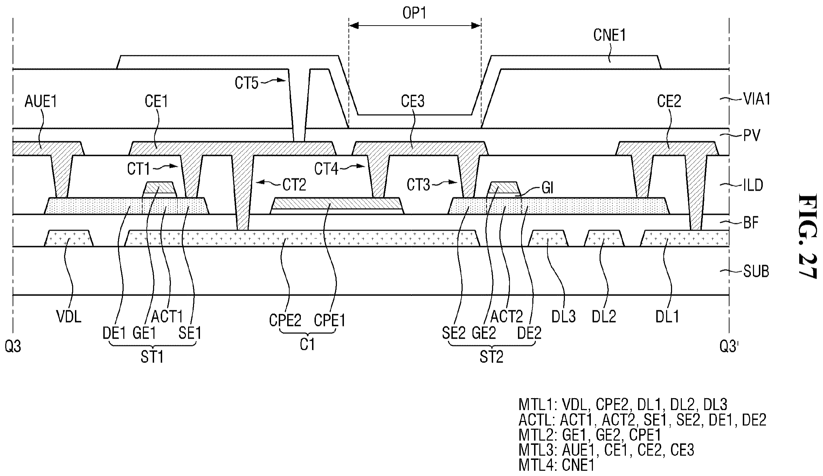

FIG. 27 is a cross-sectional view of a thin-film transistor layer of a display device according to an embodiment. FIG. 27 illustrates a structure cut through the same portion as that of FIG. 16 described above.

Referring to FIG. 27, the current embodiment is different from the embodiment of FIGS. 14 through 16 in that the thin-film transistor layer further includes a first via layer VIA1 and a fourth metal layer MTL4. Since the arrangement of the first through third openings OP1 through OP3 of the first via layer VIA1 and the fourth metal layer MTL4 is the same as that of FIGS. 17 through 20 described above, the current embodiment will be described using the first opening OP1 as an example.

A second capacitor electrode CPE2 may overlap a gate electrode GE1 and a source electrode SE1 of a first transistor ST1 and a source electrode SE2 of a second transistor ST2. In addition, the second capacitor electrode CPE2 may overlap a first connection pattern CE1 and a third connection pattern CE3 of a third metal layer MTL3. The second capacitor electrode CPE2 may overlap a third contact hole CT3 and a fourth contact hole CT4 overlapping the third connection pattern CE3. Specifically, the second capacitor electrode CPE2 may overlap the fourth contact hole CT4 connected to the third connection pattern CE3 and a first capacitor electrode CPE1 and may overlap the third contact hole CT3 connected to the third connection pattern CE3 and the source electrode SE2 of the second transistor ST2.

The second capacitor electrode CPE2 may be extended to overlap the fourth contact hole CT4 and increase an overlap area with the first capacitor electrode CPE1, thereby increasing the capacitance of a first capacitor C1. In addition, since the second capacitor electrode CPE2 further forms a capacitor with the source electrode SE2 of the second transistor ST2, the capacitance of the first capacitor C1 can be further increased.

The first via layer VIA1 may include the first opening OP1 overlapping the third connection pattern CE3. The first opening OP1 may overlap the third and fourth contact holes CT3 and CT4. A first connection electrode CNE1 of the fourth metal layer MTL4 may directly contact a passivation layer PV exposed through the first opening OP1.

The first capacitor C1 of a first pixel SP1 may be formed not only between the first capacitor electrode CPE1 and the second capacitor electrode CPE2 and between the first capacitor electrode CPE1 and the first connection pattern CE1 but also between the first connection electrode CNE1 and the third connection pattern CE3. Therefore, the capacitance of the first capacitor C1 of each pixel SP1, SP2 or SP3 can be increased. In addition, since the first via layer VIA1 is removed from an area where the first opening OP1 of the first via layer VIA1 is disposed, only the passivation layer PV may be disposed between the third connection pattern CE3 and the first connection electrode CNE1, thereby further increasing the capacitance of a capacitor formed by the third connection pattern CE3 and the first connection electrode CNE1.

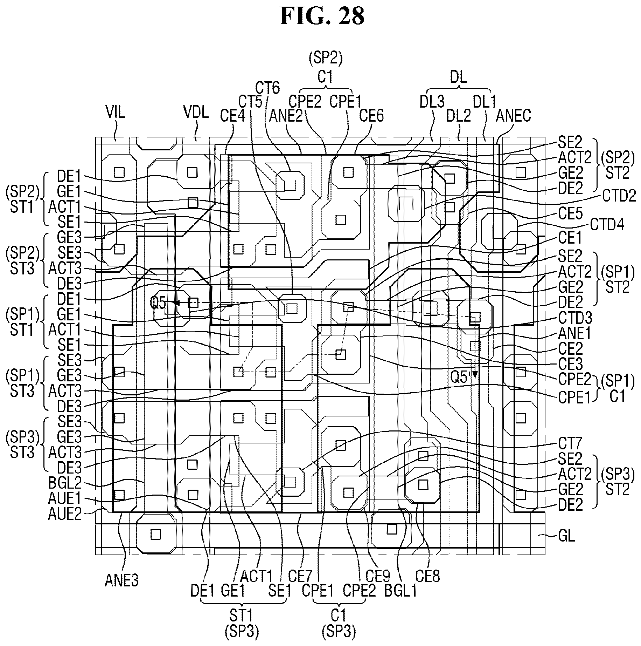

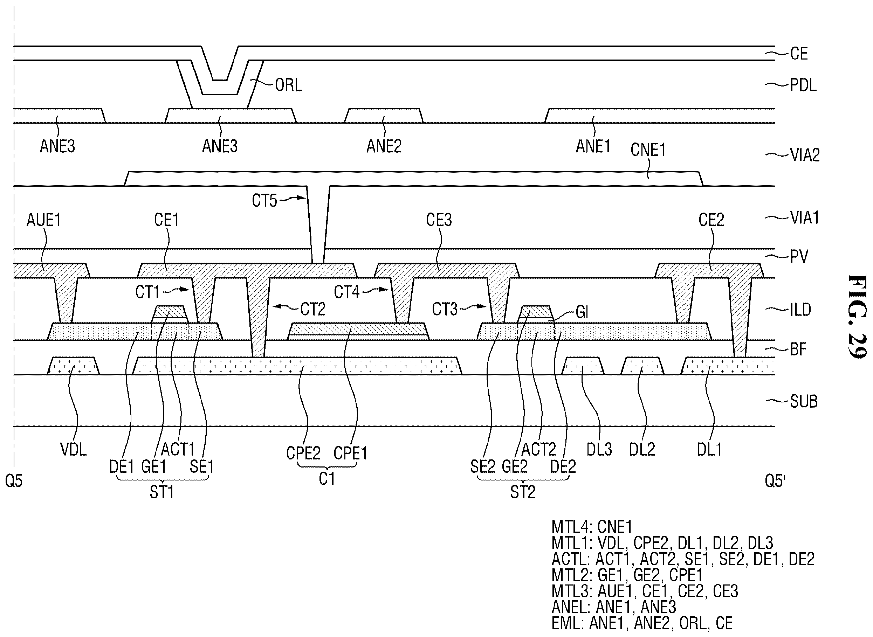

FIG. 28 is a plan view of a display device according to an embodiment. FIG. 29 is a cross-sectional view taken along line Q5-Q5' of FIG. 28. FIG. 28 further shows a pixel electrode layer ANEL in FIG. 17, and FIG. 29 further shows a second via layer VIA2, the pixel electrode layer ANEL, a pixel defining layer PDL, an organic layer ORL, and a common electrode CE.

Referring to FIGS. 28 and 29, the display device according to the embodiment may further include the second via layer VIA2, the pixel defining layer PDL, and a light emitting element layer EML.

The second via layer VIA2 may be disposed on a first via layer VIA1 and first through fourth connection electrodes CNE1 through CNE4 of a fourth metal layer MTL4. The second via layer VIA2 flattens a step thereunder so that the light emitting element layer EML can be easily formed.

The light emitting element layer EML may be disposed on the second via layer VIA2. The light emitting element layer EML may include the pixel electrode layer ANEL, the organic layer ORL, and the common electrode CE. The pixel electrode layer ANEL may include first through third pixel electrodes ANE1 through ANE3 and a pixel auxiliary electrode ANEC. The first pixel electrode ANE1 may be connected to a pixel circuit of a first pixel SP1 through a first contact portion CTD1. For example, the first pixel electrode ANE1 may be connected to the first connection electrode CNE1 through the first contact portion CTD1. The second pixel electrode ANE2 may be connected to a pixel circuit of a second pixel SP2 through a second contact portion CTD2. For example, the second pixel electrode ANE2 may be connected to the second connection electrode CNE2 through the second contact portion CTD2. The third pixel electrode ANE3 may be connected to a pixel circuit of a third pixel SP3 through a third contact portion CTD3. For example, the third pixel electrode ANE3 may be connected to the third connection electrode CNE3 through the third contact portion CTD3. The pixel auxiliary electrode ANEC may be connected to the fourth connection electrode CNE4 through a fourth contact portion CTD4.

The pixel defining layer PDL may be disposed on the pixel electrode layer ANEL and the second via layer VIA2 to define pixels. For example, the pixel defining layer PDL may expose a portion of each of the pixel electrodes ANE1 through ANE3 to define an emission area of each of the pixels SP1 through SP3.

The organic layer ORL may be disposed on each of the pixel electrodes ANE1 through ANE3. The organic layer ORL may include at least an organic light emitting layer and may emit light of first through third colors. For example, the first pixel SP1 may emit light of a first color or red light, the second pixel SP2 may emit light of a second color or green light, and the third pixel SP3 may emit light of a third color or blue light.

The common electrode CE may be disposed on the pixel defining layer PDL and the organic layer ORL. The common electrode CE may be disposed in the entire display area to apply a common voltage to each of the pixels SP1 through SP3.

Although the embodiments of the present invention have been described above with reference to the accompanying drawings, it will be understood by those of ordinary skill in the art to which the present invention pertains that the present invention may be embodied in other specific forms without changing the technical spirit or essential characteristics of the present invention. Therefore, the embodiments described above are to be understood as illustrative in all respects and not restrictive.

## Claims

1. A display device comprising:
a first voltage line disposed on a substrate and supplying a high potential voltage;
a data line spaced apart from the first voltage line and supplying a data voltage;
a first capacitor electrode disposed between the first voltage line and the data line;
a buffer layer disposed on the first voltage line, the data line, and the first capacitor electrode;
a second capacitor electrode disposed on the buffer layer and disposed on the first capacitor electrode;
a first transistor disposed on the buffer layer and connected to the data line;
an interlayer insulating layer disposed on the second capacitor electrode and the first transistor; and
a first connection pattern disposed on the interlayer insulating layer and connected to the second capacitor electrode and the first transistor,
wherein the first connection pattern is connected to the second capacitor electrode through a first contact hole penetrating the interlayer insulating layer and connected to the first transistor through a second contact hole penetrating the interlayer insulating layer, and the first capacitor electrode overlaps the first connection pattern.

2. The display device of claim 1, wherein the first capacitor electrode overlaps the first contact hole and does not overlap the second contact hole.

3. The display device of claim 1, wherein the first capacitor electrode does not overlap the first contact hole and overlaps the second contact hole.

4. The display device of claim 3, wherein a capacitor is formed between the first capacitor electrode and a source electrode of the first transistor.

5. The display device of claim 1, wherein the first capacitor electrode overlaps the first contact hole and the second contact hole.

6. The display device of claim 1, further comprising:
a second transistor disposed on the buffer layer; and
a second connection pattern overlapping the second transistor and disposed on the interlayer insulating layer,
wherein the second transistor is electrically connected to the first voltage line.

7. The display device of claim 6, further comprising:
a first via layer disposed on the interlayer insulating layer, the first connection pattern, and the second connection pattern; and
a first connection electrode disposed on the first via layer and connected to the second connection pattern through a third contact hole penetrating the first via layer.

8. The display device of claim 7, wherein the first connection pattern, the first connection electrode and the first capacitor electrode overlap each other, and a capacitor is formed between the first connection pattern and the first connection electrode.

9. The display device of claim 6, wherein the second connection pattern is connected to the second transistor through a fourth contact hole penetrating the interlayer insulating layer and is connected to the first capacitor electrode through a fifth contact hole penetrating the interlayer insulating layer and the buffer layer.

10. The display device of claim 9, wherein a capacitor is formed between the first capacitor electrode and the second capacitor electrode and between the second capacitor electrode and the second connection pattern.

11. A display device comprising:
a first voltage line disposed on a substrate and supplying a high potential voltage;
a data line spaced apart from the first voltage line and supplying a data voltage;
a first capacitor electrode disposed between the first voltage line and the data line;
a buffer layer disposed on the first voltage line, the data line, and the first capacitor electrode;
a second capacitor electrode disposed on the buffer layer and disposed on the first capacitor electrode;
a first transistor disposed on the buffer layer and connected to the data line and a second transistor connected to the first voltage line;
an interlayer insulating layer disposed on the second capacitor electrode, the first transistor, and the second transistor;
a first connection pattern disposed on the interlayer insulating layer and connected to the second capacitor electrode and the first transistor and a second connection pattern connected to the first capacitor electrode and the second transistor;
a passivation layer disposed on the interlayer insulating layer, the first connection pattern, and the second connection pattern;
a first via layer disposed on the passivation layer; and
a first connection electrode disposed on the first via layer and connected to the second connection pattern through a third contact hole penetrating the passivation layer and the first via layer,
wherein the first connection pattern is connected to the second capacitor electrode through a first contact hole penetrating the interlayer insulating layer and connected to the first transistor through a second contact hole penetrating the interlayer insulating layer, the first via layer comprises an opening overlapping at least one of the first contact hole and the second contact hole, and the first connection electrode is disposed on the first via layer and the opening.

12. The display device of claim 11, wherein the opening of the first via layer penetrates the first via layer to expose an upper surface of the passivation layer, and the first connection electrode extends from an upper surface of the first via layer to the upper surface of the passivation layer.

13. The display device of claim 11, wherein the first connection electrode and the first connection pattern overlap each other, and a capacitor is formed between the first connection electrode and the first connection pattern.

14. The display device of claim 11, wherein the opening of the first via layer does not overlap the first capacitor electrode.

15. The display device of claim 11, wherein the first capacitor electrode overlaps the first contact hole, and the opening of the first via layer overlaps the first contact hole and the first capacitor electrode.

16. The display device of claim 11, wherein the first capacitor electrode overlaps the first contact hole and the second contact hole, and the opening of the first via layer overlaps the first contact hole, the second contact hole and the first capacitor electrode.

17. The display device of claim 11, wherein the first capacitor electrode overlaps the second contact hole, and the opening of the first via layer overlaps the second contact hole and the first capacitor electrode.

18. A display device comprising:
a first voltage line supplying a high potential voltage and extending in a first direction;
a data line supplying a data voltage and extending in the first direction;
a first transistor electrically connected to the first voltage line;
a first connection pattern connected to the first transistor;
a first capacitor electrode electrically connected to the first connection pattern to receive a high potential voltage;
a second transistor electrically connected to the data line;
a second connection pattern connected to the second transistor;
a second capacitor electrode connected to the second connection pattern to receive a data voltage;
an interlayer insulating layer disposed between the first transistor and the first connection pattern and between the second transistor and the second connection pattern; and
a buffer layer disposed between the first voltage line, the first capacitor electrode and the data line and the first transistor and the second transistor,
wherein the second connection pattern is connected to the second capacitor electrode and the second transistor through contact holes formed in the interlayer insulating layer, and the first capacitor electrode overlaps the first transistor and the second capacitor electrode and overlaps at least one of the contact holes.

19. The display device of claim 18, wherein the first capacitor electrode overlaps the whole of the second capacitor electrode.

20. The display device of claim 18, wherein the first capacitor electrode overlaps at least a portion of the second connection pattern.

21. The display device of claim 18, further comprising:
a passivation layer disposed on the first connection pattern, the second connection pattern, and the interlayer insulating layer;
a first via layer disposed on the passivation layer; and
a first connection electrode disposed on the first via layer and electrically connected to the first connection pattern through a contact hole formed in the passivation layer and the first via layer,
wherein the first connection electrode overlaps the second connection pattern.

22. The display device of claim 21, further comprising:
a second via layer disposed on the first connection electrode and the first via layer;
a pixel electrode disposed on the second via layer and electrically connected to the first connection electrode;
an organic layer disposed on the pixel electrode; and
a common electrode disposed on the organic layer.
